(19) Europäisches Patentamt
European Patent Office
Office européen des brevets

(11) **EP 4 475 435 A1**

(12) **EUROPEAN PATENT APPLICATION**
published in accordance with Art. 153(4) EPC

(43) Date of publication:
**11.12.2024 Bulletin 2024/50**

(21) Application number: **23778532.4**

(22) Date of filing: **03.04.2023**

(51) International Patent Classification (IPC):
**H03H 9/17** $^{(2006.01)}$

(52) Cooperative Patent Classification (CPC):
**H03H 9/17**

(86) International application number:
**PCT/CN2023/085909**

(87) International publication number:
**WO 2023/186168 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.04.2022 CN 202210347471
28.03.2023 CN 202310323859**

(71) Applicant: **Huawei Technologies Co., Ltd.
Shenzhen, Guangdong 518129 (CN)**

(72) Inventors:
• **SUN, Fengpei
Shenzhen, Guangdong 518129 (CN)**
• **FENG, Zhihong
Shenzhen, Guangdong 518129 (CN)**
• **XU, Jinghui
Shenzhen, Guangdong 518129 (CN)**
• **HUANG, Linhai
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **RESONATOR, ELECTRONIC COMPONENT AND RESONANT SYSTEM**

(57) This application discloses a resonator, an electronic component, and a resonant system, and belongs to the field of micro-electro-mechanical technologies. The resonator includes a first sub-resonator and a plurality of second sub-resonators. The first sub-resonator in vibration deforms in at least two non-parallel directions, the first sub-resonator is connected to the second sub-resonators in all the at least two non-parallel directions, and deformations in all the at least two non-parallel directions couple the first sub-resonator to the second sub-resonators. Then, the resonator can balance a Q value and Rm, and can have a higher Q value and lower Rm. In addition, in a design phase, a TCF turnover point temperature of the resonator can be designed according to a requirement, to customize the TCF turnover point temperature.

FIG. 11

**Description**

This application claims priorities to Chinese Patent Application No. 202210347471.4, filed on April 1, 2022 and entitled "RESONATOR, ELECTRONIC COMPONENT, AND RESONANT SYSTEM", and to Chinese Patent Application No. 202310323859.5, filed on March 28, 2023 and entitled "RESONATOR, ELECTRONIC COMPONENT, AND RESONANT SYSTEM", both of which are incorporated herein by reference in their entireties.

**TECHNICAL FIELD**

This application relates to the field of micro-electro-mechanical technologies, and in particular, to a micro-electro-mechanical resonator, electronic component, and resonant system.

**BACKGROUND**

Resonators are devices for electrical frequency selection through acoustic wave resonance, and are widely used in electronic components such as an oscillator and a filter.

Main performance parameters of the resonators include a quality factor (Quality factor, Q) and a dynamic impedance Rm. A high Q value can reduce the dynamic impedance Rm, reduce phase noise, and improve frequency stability. A low dynamic impedance Rm can reduce far-out phase noise of a used oscillator. The far-out phase noise is phase noise generated far from a resonant frequency.

**SUMMARY**

This application provides a resonator, to resolve a problem in the conventional technology that it is difficult for a conventional resonator to balance a Q value and Rm. The technical solution is as follows.

According to a first aspect, an embodiment of this application provides a resonator. The resonator includes a first sub-resonator and a plurality of second sub-resonators. The first sub-resonator in vibration deforms in at least two non-parallel directions, the first sub-resonator is connected to the second sub-resonators in all the at least two non-parallel directions, and deformations in all the at least two non-parallel directions couple the first sub-resonator to the second sub-resonators.

That the first sub-resonator can be coupled to the second sub-resonators may be understood as that when resonant frequencies of the first sub-resonator and the second sub-resonators are equal or approximately equal, deformations in these directions can enable resonance or approximate resonance of the first sub-resonator and the second sub-resonators.

It should be noted that a resonant frequency of the first sub-resonator is correlated with a vibration mode of the first sub-resonator. For example, the first sub-resonator corresponds to one resonant frequency in a Lamé mode, and corresponds to another resonant frequency in an SE mode. Similarly, for the second sub-resonator, a resonant frequency of the second sub-resonator is also correlated with a vibration mode of the second sub-resonator. In this case, the first sub-resonator can be coupled to the second sub-resonators. For example, the first sub-resonator in the Lamé mode can be coupled to the second sub-resonators in a breathing mode, which may be understood as that the resonant frequency corresponding to the first sub-resonator in the Lamé mode is equal to or approximately equal to resonant frequencies corresponding to the second sub-resonators in the breathing mode.

In this embodiment of this application, the first sub-resonator in vibration deforms in the at least two non-parallel directions. For example, a plate-shaped first sub-resonator in vibration deforms in both a first direction (for example, a horizontal direction) and a second direction (for example, a vertical direction), and both a deformation amount in the first direction and a deformation amount in the second direction are large, to couple the first sub-resonator to the second sub-resonators.

Deformation amounts in the at least two non-parallel directions may be equal or approximately equal.

In this embodiment of this application, the first sub-resonator is connected to the second sub-resonators in all the at least two non-parallel directions. For example, the first sub-resonator is connected to a second sub-resonator in a positive direction of the first direction (for example, at a right end of the first sub-resonator), and/or connected to a second sub-resonator in a negative direction of the first direction (for example, at a left end of the first sub-resonator). The first sub-resonator is connected to a second sub-resonator in a positive direction of the second direction (for example, at an upper end of the first sub-resonator), and/or connected to a second sub-resonator in a negative direction of the second direction (for example, at a lower end of the first sub-resonator). It can be seen that a larger quantity of second sub-resonators can be connected around the first sub-resonator.

In this embodiment of this application, for the resonator obtained after the first sub-resonator is coupled to the second sub-resonators, a Q value of the coupled resonator can be increased via the first sub-resonator, Rm of the coupled resonator can be reduced based on the quantity of second sub-resonators. Then, the resonator balances the Q value and Rm, and can have a higher Q value and lower Rm.

For example, deformation amounts of the first sub-resonator in all the at least two directions are large, for example, approximate to each other while phases are opposite, so that a volume of the first sub-resonator is basically unchanged, and stress suffered by the first sub-resonator is small. This can reduce unevenness of stress applied to all parts of the first sub-resonator, and can further reduce a temperature gradient, thereby reducing an energy loss and increasing the Q value. If the first sub-resonator has vibration deformations in the at least two directions, the first sub-resonator can be connected to the second sub-resonators in the at least two directions. For example, the first sub-resonator is separately connected to one second sub-resonator in a positive direction and a negative direction of one direction, and separately connected to one second sub-resonator in a positive direction and a negative direction of another direction. In this way, the resonator can include a larger quantity of second sub-resonators, and the larger quantity of second sub-resonators indicates a larger sensing area A of electrodes of the second sub-resonators, and smaller Rm. Therefore, increasing the quantity of second sub-resonators can increase the sensing area A of electrodes, and reduce Rm of the coupled resonator. Then, the Q value of the resonator can be increased via the first sub-resonator, and Rm of the resonator can be reduced based on the quantity of second sub-resonators.

In addition, a TCF turnover point temperature of the coupled resonator is between an intrinsic TCF turnover point temperature of the first sub-resonator and an intrinsic TCF turnover point temperature of each second sub-resonator. In addition, the TCF turnover point temperature can be customized by adjusting the vibration mode of the first sub-resonator, a vibration mode of each second sub-resonator, the quantity of second sub-resonators, and the like.

In a possible implementation, a shape of the first sub-resonator is a plate shape. For example, a shape of a first resonator element of the first sub-resonator is a plate shape.

The plate shape may be a square plate shape, a rectangular plate shape, or a disc plate shape. The disc plate shape may further be a circular disc plate shape, or an elliptical disc plate shape.

In this embodiment of this application, the plate-shaped first sub-resonator in vibration can deform in the at least two non-parallel directions. For example, the first sub-resonator in vibration can deform in a left direction, a right direction, an upper direction, and a lower direction. These deformations can be for coupling the first sub-resonator to the second sub-resonators. In this case, a left side and a right side of the plate-shaped first sub-resonator are separately connected to one second sub-resonator, and an upper side and a lower side of the plate-shaped first sub-resonator are separately connected to one second sub-resonator. In this way, the plate-shaped first sub-resonator is coupled to a larger quantity of second sub-resonators, and the larger quantity of second sub-resonators can increase a sensing area to reduce Rm of the resonator.

In addition, deformations in the left direction and the right direction of the plate-shaped first sub-resonator can couple the first sub-resonator to the second sub-resonators, and deformations in the up direction and the down direction of the first sub-resonator can couple the first sub-resonator to the second sub-resonators. It indicates that deformation amounts in the left direction and the right direction of the first sub-resonator and deformation amounts in the up direction and the down direction of the first sub-resonator are large. For example, if the deformation amounts in the left direction and the right direction of the first sub-resonator are equal or approximately equal to the deformation amounts in the up direction and the down direction of the first sub-resonator, the volume of the first sub-resonator is basically unchanged, and the stress suffered by the first sub-resonator is small. This can reduce the unevenness of the stress applied to all the parts of the first sub-resonator, and can further reduce the temperature gradient, thereby reducing the energy loss and increasing the Q value.

In a possible implementation, a vibration mode of the first sub-resonator is a bulk mode.

In a possible implementation, an acoustic wave generated by the first sub-resonator in vibration is a transverse wave.

The transverse wave may also be referred to as a shear wave.

In this embodiment of this application, in the bulk mode, the acoustic wave generated in vibration is a bulk acoustic wave, and the bulk acoustic wave is an acoustic wave propagated inside an object. The bulk acoustic wave includes a transverse wave and a longitudinal wave. The acoustic wave generated by the first sub-resonator in vibration may be the transverse wave or the longitudinal wave. To increase an intrinsic Q value of the first sub-resonator, the acoustic wave generated by the first sub-resonator in vibration may be the transverse wave. This is because during propagation of the transverse wave, the volume of the first sub-resonator is basically unchanged, so that internal force is even, and a thermal gradient is small, resulting in small thermoelastic dissipation ($Q_{TED}$). In this case, the Q value is large. Therefore, the acoustic wave generated by the first sub-resonator in vibration may be the transverse wave, to increase the intrinsic Q value of the first sub-resonator, thereby increasing the Q value of the resonator.

In a possible implementation, the vibration mode of the first sub-resonator is one of a Lamé Lamé mode, a square extensional SE mode, a face-shear FS mode, a breathing mode, a wine glass WG mode, and a width-shear WS mode.

The breathing mode may be a circular disc breathing mode, or may be a circular ring breathing mode.

In a possible implementation, the first sub-resonator is symmetric, the plurality of second sub-resonators are grouped into at least two groups, and each group of second sub-resonators includes two second sub-resonators.

The two second sub-resonators in each group of second sub-resonators are symmetrically distributed about a symmetry axis of the first sub-resonator.

In an example, the two second sub-resonators in each group of second sub-resonators are symmetrically distributed in a positive direction and a negative direction of a deformation direction. For example, if the first sub-resonator deforms in the first direction and the second direction, a group of second sub-resonators are symmetrically distributed in the positive direction and the negative direction of the first direction, and another group of second sub-resonators are symmetrically distributed in the positive direction and the negative direction of the second direction.

In this embodiment of this application, the two second sub-resonators in each group of second sub-resonators are symmetrically distributed about the symmetry axis of the first sub-resonator, and vibration modes of second sub-resonators in a same group are the same, to synchronize vibration of the two second sub-resonators in the same group to avoid affecting vibration effect of the first sub-resonator.

In a possible implementation, the first sub-resonator includes a first resonator element and a first electrode, and the first electrode is distributed at a side of the first resonator element, so that the first resonator element and the first electrode form an electrostatic resonator.

In this embodiment of this application, the first electrode is located at the side of the first resonator element, for the first electrode and the first resonator element to form the electrostatic resonator. In a same condition, for example, at a same resonant frequency, a Q value of an electrostatic resonator is usually higher than a Q value of a piezoelectric resonator. Therefore, the Q value of the resonator can be increased by increasing the intrinsic Q value of the first sub-resonator.

In a possible implementation, the first sub-resonator further includes a piezoelectric layer and an upper electrode layer, the piezoelectric layer covers a surface of the first resonator element, and the upper electrode layer covers a surface that is of the piezoelectric layer and that is away from the first resonator element, so that the first resonator element, the piezoelectric layer, and the upper electrode layer form a piezoelectric resonator.

The first resonator element may be used as a base layer of the piezoelectric resonator, or may be used as a lower electrode layer of the piezoelectric resonator.

In this embodiment of this application, the first sub-resonator includes the first electrode, the piezoelectric layer, and the upper electrode layer, for the first electrode and the first resonator element to form the electrostatic resonator, to increase the intrinsic Q value of the first sub-resonator, and increase the Q value of the resonator. The first resonator element, the piezoelectric layer, and the upper electrode layer form the piezoelectric resonator. If the upper electrode layer is used as a detection electrode, detection signal strength can be increased. If the upper electrode layer is used as a drive electrode, drive signal strength can be increased.

In addition, in a same condition, for example, at a same resonant frequency, Rm of a piezoelectric resonator is usually lower than Rm of an electrostatic resonator. Therefore, the first resonator element, the piezoelectric layer, and the upper electrode layer form the piezoelectric resonator, helping reduce Rm of the resonator.

In a possible implementation, the first sub-resonator in vibration includes a plurality of vibration types.

There are a plurality of piezoelectric layers, each piezoelectric layer covers the surface of the first resonator element, and vibration types in a covered area are the same.

There are a plurality of upper electrode layers, and a surface that is of each piezoelectric layer and that is away from the first resonator element is covered by the upper electrode layer.

In this embodiment of this application, vibration types of the first resonator element in vibration in all areas may be different. For example, if the vibration mode of the first sub-resonator is the Lamé mode, the FS mode, the WS mode, or the WG mode, the first resonator element in vibration performs extension vibration in some areas, and performs contraction vibration in some areas. In this case, extension vibration and contraction vibration cannot be both included in an area of the first resonator element covered by a same piezoelectric layer. This is because an electric charge generated by the piezoelectric layer due to the extension vibration and an electric charge generated by the piezoelectric layer due to the contraction vibration have opposite electrical properties, resulting in neutralization of the electric charges of the piezoelectric layer and loss of piezoelectric effect. Therefore, vibration types of areas that are of the first resonator element and that are covered by a same piezoelectric layer are the same.

In addition, to enhance the piezoelectric effect, correspondingly, the plurality of piezoelectric layers may be selected based on the vibration types of the first resonator element in all the areas. Each piezoelectric layer covers the surface of the first resonator element, and vibration types in a covered area are the same. An upper surface of each piezoelectric layer needs to be covered by an upper electrode layer. In this case, there are the plurality of upper electrode layers, and a surface that is of each piezoelectric layer and that is away from the first resonator element is covered by an upper electrode layer. When there are the plurality of piezoelectric layers, to avoid affecting vibration of two adjacent piezoelectric layers, correspondingly, there is a spacing between the two adjacent piezoelectric layers, and there is also a spacing between two adjacent upper electrode layers.

In a possible implementation, a shape of the piezoelectric layer is a triangle or trapezoid shape.

In this embodiment of this application, the triangle-shaped piezoelectric layer has a larger contact area with all the areas, and the larger contact area indicates higher piezoelectric effect of the piezoelectric layer and better vibration effect.

In a possible implementation, a shape of the first resonator element of the first sub-resonator is a square, rectangle, or disc shape.

The disc shape may be a circular disc shape, or may be an elliptic disc shape.

In a possible implementation, a vibration mode of the second sub-resonator is one of a breathing mode, a Lamé Lamé mode, a square extensional SE mode, a face-shear FS mode, a wine glass WG mode, and a width-shear WS mode.

In a plurality of included solutions for the second sub-resonator, vibration modes of second sub-resonators in different groups may be the same or may be different. For example, vibration modes of a group of second sub-resonators may be the Lamé mode, and vibration modes of another group of second sub-resonators may be the breathing mode.

In this embodiment of this application, because the Lamé mode or the SE mode can excite a higher Q value, the resonator can use a second sub-resonator whose vibration mode is the Lamé mode or the SE mode to increase the Q value.

In a possible implementation, the second sub-resonator is an electrostatic resonator including a second resonator element and a second electrode.

In this embodiment of this application, the second sub-resonator is the electrostatic resonator. A total sensing area may be increased by increasing a sensing area between the second resonator element and the second electrode, to reduce intrinsic Rm of the second sub-resonator, thereby reducing Rm of the resonator.

In a possible implementation, a shape of a second resonator element of at least one second sub-resonator is a ring shape, and a second electrode is distributed inside and/or outside a ring of the ring-shaped second resonator element.

In this embodiment of this application, for a second sub-resonator whose vibration mode is a ring-shaped breathing mode, a shape of a second resonator element of the second sub-resonator may be a ring shape. The shape of the second resonator element is the ring shape, so that the second electrode is disposed inside and/or outside the ring of the ring-shaped second resonator element. In this way, a sensing area between the second resonator element and the second electrode can be increased, especially when the second electrode is disposed both inside and outside the ring of the second resonator element.

In a possible implementation, a shape of a second resonator element of at least one second sub-resonator is a disc shape. A second electrode of the disc-shaped second sub-resonator is located outside a disc of the second resonator element of the disc-shaped second sub-resonator, and is distributed in a disc circumferential direction of the second resonator element.

The shape of the second resonator element may be a circular disc. In this case, the second electrode is located outside the disc, and is distributed in a circumferential direction of the circular disc. Alternatively, the shape of the second resonator element may be an elliptic disc. In this case, the second electrode is located outside the disc, and is distributed in an elliptical circumferential direction of the elliptic disc.

In this embodiment of this application, for a second sub-resonator whose vibration mode may be a disc-shaped breathing mode, a shape of a second resonator element of the second sub-resonator may be a disc shape. In this case, the second electrode may be distributed outside the disc in the disc circumferential direction. In this way, a sensing area of the second electrode can alternatively be increased, thereby reducing intrinsic Rm of the disc-shaped second sub-resonator and then reducing Rm of the resonator.

In a possible implementation, an outer sidewall of the second resonator element of the at least one second sub-resonator has a plurality of curvature radii, so that the second sub-resonator has oriented crystallinity.

In this embodiment of this application, the outer sidewall of the second resonator element has the plurality of curvature radii, so that the second resonator element has the oriented crystallinity. In this case, a relationship between the crystal orientation of the second sub-resonator having the oriented crystallinity and a crystal orientation of a wafer in which the second sub-resonator is located can be adjusted to adjust the TCF turnover point temperature of the resonator.

In a possible implementation, the outer sidewall of the second resonator element of the at least one second sub-resonator has a cut-off face.

In this embodiment of this application, the outer sidewall of the second resonator element has the cut-off face, and a curvature radius at the cut-off face is infinitely large, thereby further enhancing the oriented crystallinity of the second sub-resonator having a cut-off face feature.

In a possible implementation, the second resonator element of the at least one second sub-resonator has a through-hole running through a thickness direction.

In this embodiment of this application, the through-hole in the second resonator element can reduce stiffness of the second resonator element. Once the stiffness of the second resonator element is reduced, an elastic coefficient of a deformation of the second resonator element is reduced. Rm of the resonator is also correlated, for example, positively correlated, with the elastic coefficient. In this case, intrinsic Rm of the second sub-resonator having a through-hole feature is reduced, thereby reducing Rm of the resonator.

In a possible implementation, the outer sidewall of the second resonator element of the at least one second sub-resonator has a plurality of protrusions.

In this embodiment of this application, the outer sidewall of the ring-shaped second resonator element has the protrusions, there may be a plurality of protrusions, and the plurality of protrusions are evenly arranged in the circumferential direction. However, the second electrode outside the ring of the ring-shaped second resonator element matches the second resonator element. In this case, an inner side wall of the second electrode has grooves. The protrusions on the second resonator element and the grooves of the second electrode can increase a sensing area A of the second electrode. Once the sensing area A is increased, Rm of the second sub-resonator having a protrusion feature can be reduced, thereby reducing Rm of the resonator.

In a possible implementation, a fastening anchor for fastening the resonator is connected to the first sub-resonator.

The fastening anchor may be connected to any position of the first sub-resonator.

In this embodiment of this application, the fastening anchor may be connected to the first sub-resonator, to reduce an anchor loss, and increase the Q value of the resonator.

In a possible implementation, the fastening anchor is connected to a position that is of the first sub-resonator and at which vibration is weakest.

In this embodiment of this application, the fastening anchor is connected to the position that is of the first sub-resonator and at which vibration is weakest, to further reduce the anchor loss, and increase the Q value.

In a possible implementation, the vibration mode of the first sub-resonator is the Lamé mode, and the fastening anchor is connected to a vertex angle of the first sub-resonator.

In this embodiment of this application, the vibration mode of the first sub-resonator is the Lamé mode. Vibration at a position of the vertex angle in the Lamé mode is weakest, or even no vibration occurs. In this case, the fastening anchor may be connected to the vertex angle of the first resonator element of the first sub-resonator.

In a possible implementation, the vibration mode of the first sub-resonator is the SE mode, and the fastening anchor is connected to a side midpoint or a vertex angle of the first sub-resonator.

In this embodiment of this application, the vibration mode of the first sub-resonator is the SE mode. Vibration at a position of the side midpoint in the SE mode is weak. In this case, the fastening anchor may be connected to the side midpoint of the first resonator element of the first sub-resonator, thereby helping reduce the anchor loss. However, the vibration mode of the first sub-resonator is the SE mode, and the fastening anchor may alternatively be connected to the vertex angle of the first resonator element of the first sub-resonator, to facilitate deployment of the first electrode around the first resonator element.

In a possible implementation, at least one second sub-resonator is connected to a position that is of the first sub-resonator and at which vibration is strongest.

In this embodiment of this application, the at least one second sub-resonator is connected to the position that is of the first sub-resonator and at which vibration is strongest, to facilitate vibration transfer between the first sub-resonator and the second sub-resonator, reduce the energy loss, and increase the Q value.

In a possible implementation, the vibration mode of the first sub-resonator is the Lamé mode, and at least one second sub-resonator is connected to a side midpoint of the first sub-resonator.

In this embodiment of this application, the vibration mode of the first sub-resonator is the Lamé mode. Vibration at a position of the side midpoint in the Lamé mode is strongest. In this case, the at least one second sub-resonator may be connected to the side midpoint of the first resonator element of the first sub-resonator.

In a possible implementation, the vibration mode of the first sub-resonator is the SE mode, and at least one second sub-resonator is connected to the vertex angle or the side midpoint of the first sub-resonator.

In this embodiment of this application, the vibration mode of the first sub-resonator is the SE mode. Vibration at a position of the vertex angle in the SE mode is strong. In this case, the at least one second sub-resonator may be connected to the vertex angle of the first resonator element of the first sub-resonator, to facilitate the vibration transfer. However, the vibration mode of the first sub-resonator is the SE mode, and the at least one second sub-resonator may alternatively be connected to the side midpoint of the first resonator element of the first sub-resonator, to facilitate deployment of the first electrode around the first resonator element.

It should be noted that if the fastening anchor is connected to a position of the vertex angle of the first resonator element of the first sub-resonator, the second resonator element of the second sub-resonator is connected to the side midpoint of the first resonator element. If the fastening anchor is connected to the side midpoint of the first resonator element of the first sub-resonator, the second resonator element of the second sub-resonator is connected to the vertex angle of the first resonator element. It may also be understood that the fastening anchor and the second resonator element cannot be connected to a same position of the first resonator element.

In a possible implementation, a material of the first sub-resonator, a material of each second sub-resonator, and a material of a coupling rod connecting the first sub-resonator to any second sub-resonator are monocrystalline silicon materials or doped monocrystalline silicon materials.

In a possible implementation, the resonator includes a drive electrode and a detection electrode, the drive electrode is configured to input a drive signal for exciting vibration, and the detection electrode is configured to output a detection signal for detecting vibration.

The drive electrode includes an electrode of the first sub-resonator and/or an electrode of at least one second sub-resonator, and the detection electrode includes an electrode of the first sub-resonator and/or an electrode of at least one second sub-resonator.

For example, there is one drive electrode, and the drive electrode may be an electrode of the first sub-resonator, or may be an electrode of a second sub-resonator. For another example, there are a plurality of drive electrodes, and all the drive electrodes may be electrodes of the first sub-resonator (in this solution, the first sub-resonator includes a plurality of electrodes), or all the drive electrodes may be electrodes of the second sub-resonators. For another example, there are a plurality of drive electrodes, some drive electrodes are electrodes of the first sub-resonator, and the remaining drive electrodes are electrodes of the second sub-resonators. Similarly, for the detection electrode, refer to the drive electrode. Details are not described herein again.

In this embodiment of this application, there are many choices and good flexibility for the drive electrode and the detection electrode of the resonator. In particular, in a solution in which the first sub-resonator is a hybrid electrostatic and piezoelectric resonator, all the second sub-resonators are electrostatic resonators, second resonator elements of all the second sub-resonators are in ring shapes, and second electrodes are distributed both inside and outside all rings, because the resonator includes many electrodes, there are even more choices for the drive electrode and the detection electrode.

In a possible implementation, a temperature coefficient of frequency TCF of the resonator is correlated with at least one of the following parameters:

the vibration mode of the first sub-resonator, the shape of the first sub-resonator, the material of the first sub-resonator, a vibration mode of each second sub-resonator, a shape of each second sub-resonator, the material of each second sub-resonator, a quantity of second sub-resonators, a relationship between the symmetry axis of the first sub-resonator and a crystal orientation of a wafer, and a relationship between a symmetry axis of a second sub-resonator having oriented crystallinity and the crystal orientation of the wafer, where the wafer is a wafer in which the resonator is located.

In this embodiment of this application, in a design phase of the resonator having the first sub-resonator coupled to the plurality of second sub-resonators, a TCF turnover point temperature of the coupled resonator can be adjusted by changing the foregoing parameters, to customize the TCF turnover point temperature of the coupled resonator.

In a possible implementation, each second sub-resonator includes a second resonator element, the second resonator element has different Young's moduli in different target crystal orientations, and the target crystal orientation is parallel to a plane in which the second resonator element is located.

A length of the second resonator element on any straight line is negatively correlated with a Young's modulus in any target crystal orientation, where the any straight line is a straight line that is parallel to the any target crystal orientation and that passes through a central position of the second resonator element.

In this embodiment of this application, if the second resonator element has a larger Young's modulus in a target crystal orientation (denoted as a first target crystal orientation), during design of the second resonator element, a length of the second resonator element may be smaller on a straight line (denoted as a first straight line) that is parallel to the first target crystal orientation and that passes through the central position of the second resonator element. In this way, a deformation amount of the second resonator element 21 in vibration in the first target crystal orientation is larger.

If the second resonator element has a smaller Young's modulus in another target crystal orientation (denoted as a second target crystal orientation), during design of the second resonator element, a length of the second resonator element may be larger on a straight line (denoted as a second straight line) that is parallel to the second target crystal orientation and that passes through the central position of the second resonator element. In this way, a deformation amount of the second resonator element in vibration in the second target crystal orientation is smaller.

In this way, deformation amounts of the second resonator element in vibration in all the target crystal orientations are neither excessively large nor excessively small. In this way, the deformation amounts in all the target crystal orientations are equivalent. In this case, heat generated from deformations at all positions of the second resonator element in vibration is similar, and a thermal gradient is small, and a heat flow is weak. In this case, energy consumed by the heat flow is also small, and thermoelastic dissipation is small. However, once the thermoelastic dissipation of the second resonator element is small, $Q_{TED}$ corresponding to the thermoelastic dissipation is large, so that the Q value of the resonator can be increased.

In a possible implementation, an absolute value of a difference between $C(\theta)'$ and $C(\theta)$ is less than or equal to 0.05 $kC_0$, where

$$C(\theta) = \left(\frac{E_0}{E(\theta)}\right)^k \times C_0$$

$C(\theta)'$ indicates an actual length of the second resonator element on the any straight line, $C(\theta)$ indicates a theoretical length of the second resonator element on the any straight line, $E(\theta)$ indicates a Young's modulus of the second resonator element in the any target crystal orientation, $\theta$ indicates an included angle between the any target crystal orientation and a reference target crystal orientation of the second resonator element, $C_0$ indicates a length of the second resonator element in the reference target crystal orientation, $E_0$ indicates a Young's modulus of the second resonator element in the reference target crystal orientation, and k is a constant greater than zero.

In this embodiment of this application, during design of the second resonator element, an actual length $C(\theta)'$ of the second resonator element on any straight line may fall within a range of plus or minus 0.05 $kC_0$ from calculated $C(\theta)$, for example, fall within a range of plus or minus 170 micrometers from calculated $C(\theta)$.

In a possible implementation, $E_0$ is less than $E(\theta)$.

In this embodiment of this application, for the reference target crystal orientation, any one of a plurality of target crystal orientations may be selected as the reference. Certainly, for ease of calculation, a special target crystal orientation is generally selected as the reference. For example, a target crystal orientation corresponding to a smallest Young's modulus may be selected, or a target crystal orientation corresponding to a largest Young's modulus may be selected. Therefore, if the target crystal orientation corresponding to the smallest Young's modulus is selected as the reference crystal orientation, $E_0$ is less than $E(\theta)$.

In a possible implementation, a shape of the second resonator element is a ring shape, and curvature radii at all positions inside and outside a ring of the second resonator element are greater than zero; and

a value range of k is greater than or equal to 0.3 and less than or equal to 0.8.

In a possible implementation, k is 0.55.

In this embodiment of this application, simulation is performed on the ring-shaped second resonator element to obtain Q values (that is, $Q_{TED}$) corresponding to thermoelastic dissipation of the second resonator element at different k values. When k is 0.55, $Q_{TED}$ is largest, and largest $Q_{TED}$ corresponds to smallest thermoelastic dissipation TED. Therefore, k may be 0.55.

Compared with a second resonator element in a ring shape with an equal annulus width, $Q_{TED}$ of the second resonator element designed according to the foregoing formula when k may be 0.55 is six times higher than $Q_{TED}$ of the second resonator element in the ring shape with the equal annulus width.

In a possible implementation, a shape of the second resonator element is a convex pattern, and curvature radii at all edge positions of the second resonator element are greater than zero; and

a value range of k is greater than or equal to 3 and less than or equal to 5.

In this embodiment of this application, for example, if the shape of the second resonator element is a disc shape, and the curvature radii at all edge positions of the second resonator element are greater than zero, the value range of k may be greater than or equal to 3 and less than or equal to 5.

In a possible implementation, k is 4.

In this embodiment of this application, simulation is performed on the second resonator element of the convex pattern, for example, the disc-shaped second resonator element 21. According to a simulation result, when k is 4, $Q_{TED}$ of the second resonator element reaches a peak value, and in this case, corresponding thermoelastic dissipation TED is smallest. Therefore, k may be 4.

In a possible implementation, at least one of the plurality of second sub-resonators further includes a second electrode, and the second sub-resonator including the second electrode is an electrostatic resonator; and

the second electrode is distributed in a circumferential direction of the second resonator element, and the second resonator element is equidistant from the second electrode in different target crystal orientations.

In this embodiment of this application, if the second sub-resonator including the second electrode is the electrostatic resonator, the second electrode and the second resonator element are arranged at a spacing. For example, the second electrode is located at a side of the second resonator element. To increase an area that the second electrode and the second resonator element face each other, the second electrode is distributed in a circumferential direction of the second resonator element.

Further, if a length on any straight line of the second resonator element that is of the second sub-resonator and that is the electrostatic resonator is negatively correlated with a Young's modulus in any target crystal orientation, any two spacings between the second resonator element and the second electrode are equal in different target crystal orientations. During application, if an absolute value of a difference between any two spacings between the second resonator element and the second electrode in different target crystal orientations are less than or equal to 170 micrometers, it may be considered that the two spacings are equal.

In a possible implementation, a material of the second resonator element is one of a monocrystalline material and a doped single crystal.

In this embodiment of this application, as a result of stiffness anisotropy of the second resonator element, the second resonator element of the second sub-resonator has different Young's moduli in different target crystal orientations. The stiffness anisotropy of the second resonator element is caused by anisotropy of the second resonator element, and the anisotropy is a property of a single crystal. Therefore, the material of the second resonator element is a single crystal or a

# EP 4 475 435 A1

doped single crystal. For example, the material of the second resonator element may be one of monocrystalline silicon, monocrystalline aluminum nitride, n-type doped single crystal, and p-type doped single crystal.

According to a second aspect, an electronic component is provided. The electronic component includes a peripheral circuit and the resonator according to the first aspect. The peripheral circuit may include a drive circuit and a detection circuit. The drive circuit is connected to a drive electrode of the resonator, and the detection circuit is connected to a detection circuit of the resonator.

According to a third aspect, a resonant system is provided. The resonant system includes the electronic component according to the second aspect.

## BRIEF DESCRIPTION OF DRAWINGS

(a) in FIG. 1 is a diagram of a phase noise spectrum according to this application, and (b) in FIG. 1 is a diagram of a temperature-frequency curve according to this application;

FIG. 2 is a diagram of a square plate resonator whose vibration mode is a Lamé mode and whose left portion and right portion perform extension vibration and upper portion and lower portion perform contraction vibration according to this application;

FIG. 3 is a diagram of a square plate resonator whose vibration mode is a Lamé mode and whose left portion and right portion perform contraction vibration and upper portion and lower portion perform extension vibration according to this application;

FIG. 4 is a diagram of a structure of an electrostatic resonator according to this application;

FIG. 5 is a schematic top view of a structure of a resonator including a first sub-resonator and a second sub-resonator according to this application;

FIG. 6 is a diagram of a square plate resonator whose vibration mode is a SE mode and that performs extension vibration according to this application;

FIG. 7 is a diagram of a square plate resonator whose vibration mode is a SE mode and that performs contraction vibration according to this application;

FIG. 8 is a diagram of a simulation result of a temperature-frequency curve according to this application;

FIG. 9 is a schematic top view of a structure in which a first sub-resonator is a piezoelectric resonator and a second sub-resonator is an electrostatic resonator according to this application;

FIG. 10 is an A-A sectional view of FIG. 9;

FIG. 11 is a schematic top view of a structure in which a first sub-resonator is an electrostatic resonator and a second sub-resonator is an electrostatic resonator according to this application;

FIG. 12 is a schematic top view of a structure in which a first sub-resonator is a hybrid resonator and a second sub-resonator is an electrostatic resonator according to this application;

FIG. 13 is a B-B sectional view of FIG. 12;

FIG. 14 is a diagram of area division of a square plate resonator whose vibration mode is a Lamé mode according to this application;

FIG. 15 is a schematic top view of a structure of a second resonator element of a second sub-resonator of a resonator according to this application;

FIG. 16 is a schematic top view of a structure of a second resonator element of a second sub-resonator of a resonator according to this application;

FIG. 17 is a schematic top view of a structure of a second resonator element of a second sub-resonator of a resonator according to this application;

FIG. 18 is a schematic top view of a structure of a second resonator element of a second sub-resonator of a resonator according to this application;

FIG. 19 is a schematic top view of a structure of a second resonator element of a second sub-resonator of a resonator according to this application;

FIG. 20 is a schematic top view of a structure of a second resonator element of a second sub-resonator of a resonator according to this application;

FIG. 21 is a diagram of dimensions in FIG. 12;

FIG. 22 is a diagram of a crystal orientation of a wafer of a resonator according to this application;

FIG. 23 is a diagram of a relationship between a symmetry axis of a resonator and a crystal orientation of a wafer in which the resonator is located according to this application;

FIG. 24 is a diagram of a relationship between a symmetry axis of a resonator and a crystal orientation of a wafer in which the resonator is located according to this application;

FIG. 25 is a diagram of a relationship between a symmetry axis of a resonator and a crystal orientation of a wafer in which the resonator is located according to this application;

FIG. 26 is a diagram of a simulation result of a temperature-frequency curve according to this application;

FIG. 27 is a diagram of a simulation result of a temperature-frequency curve according to this application;

FIG. 28 is a diagram of a relationship between Young's moduli in different crystal orientations of a monocrystalline silicon in a crystal plane according to this application;

FIG. 29 is a diagram of a structure of a second resonator element according to this application;

FIG. 30 is a diagram of a structure of a second resonator element according to this application;

FIG. 31 is a diagram of a relationship between $Q_{TED}$ of a second resonator element shown in FIG. 29 and a constant k according to this application;

FIG. 32 is a diagram of a first-order breathing mode of the second resonator element shown in FIG. 29 according to this application;

FIG. 33 is a diagram of a second-order breathing mode of the second resonator element shown in FIG. 29 according to this application;

FIG. 34 is a diagram in which a first resonator element is connected to a position at which an annulus width of the second resonator element shown in FIG. 29 is widened according to this application; and

FIG. 35 is a diagram in which a first resonator element is connected to a position at which an annulus width of the second resonator element shown in FIG. 29 is narrowed according to this application.

1: first sub-resonator; 11: first resonator element; 12: first electrode; 13: piezoelectric layer; 14: upper electrode layer; and

2: second sub-resonator; 21: second resonator element; 22: second electrode; 211: through-hole; 212: protrusion; 213: cut-off face; 3: coupling rod; 4: fastening anchor; and 5: connecting beam.

## DESCRIPTION OF EMBODIMENTS

Embodiments of this application provide a resonator, which may be specifically a micro-electro-mechanical system (micro-electro-mechanical System, MEMS) resonator. The MEMS resonator is a component based on mechanical resonance effect, and a microresonator that is manufactured based on an advanced semiconductor processing technology and that integrates a microsensor, a microactuator, a micro-mechanical structure, a signal processing unit, a control circuit, and the like, and has advantages of a small size, light weight, low power consumption, a low price, stable performance, and high integration. The MEMS resonator is a most basic component included in an MEMS oscillator, a clock generator, and various resonant sensors, and is widely applied.

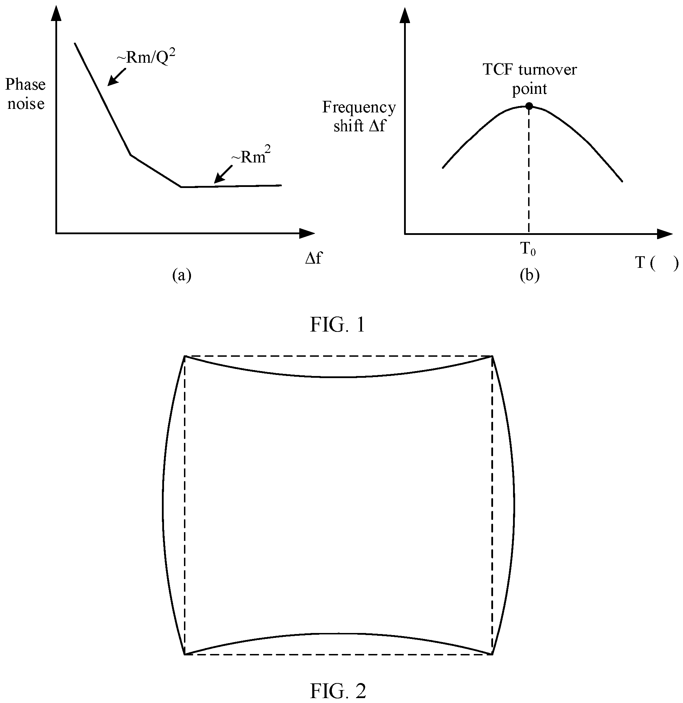

Main performance parameters of the resonator include a resonant frequency, a quality factor (quality factor, Q), a dynamic impedance Rm, and a temperature coefficient of frequency (temperature coefficient of frequency, TCF). The resonant frequency is a natural frequency of the resonator, and is a frequency at which resonance occurs. A high Q value can reduce the dynamic impedance Rm, reduce phase noise, and improve frequency stability. A low dynamic impedance Rm can reduce far-out phase noise of a used oscillator. The far-out phase noise is phase noise generated far from the resonant frequency, (a) in FIG. 1 is a diagram of a phase noise spectrum of an oscillator when a resonator is used in the oscillator. Δf indicates a difference between a frequency output by the oscillator and a resonant frequency of the resonator. As shown in (a) in FIG. 1, close-in phase noise of the oscillator is correlated with a Q value and Rm of the resonator. A higher Q value indicates lower Rm, and lower close-in phase noise. Far-out phase noise of the oscillator is correlated with Rm of the resonator. Lower Rm indicates lower close-in phase noise. The close-in phase noise is phase noise generated close to the resonant frequency, and the far-out phase noise is phase noise generated far from the resonant frequency. Lower phase noise indicates better frequency stability of the oscillator. It can be seen that the Q value and Rm of the resonator are critical to reducing phase noise of the oscillator and improving frequency stability of the oscillator. Therefore, a resonator with a high Q value and low Rm is a basis for implementing a high-performance oscillator.

The TCF may be understood as a relative average change rate of a frequency when a temperature is increased by one degree Celsius within a specific temperature range. For details, refer to (b) in FIG. 1. A slope of a frequency-temperature curve may be understood as a TCF. (b) in FIG. 1 is a frequency-temperature curve of an oscillator in which a resonator is used.

A TCF and a TCF turnover point determine a temperature point and a temperature range at which the resonator can stably work. When the resonator works close to a TCF turnover point temperature (that is, a temperature $T_0$ corresponding to the TCF turnover point), the oscillator in which the resonator is used has a very small frequency shift and excellent frequency stability. Therefore, if the TCF turnover point temperature of the resonator is high, a temperature of an operating environment of the resonator may be heated, so that the temperature of the operating environment of the resonator is close to the TCF turnover point temperature.

Therefore, based on the foregoing performance parameters of the resonator, a higher Q value and lower Rm of the resonator are preferred, and a lower TCF turnover point temperature is preferred. Because the lower TCF turnover point temperature indicates that an operating temperature of the resonator may not be high, and the operating environment of the resonator may not be heated to a high temperature, thereby reducing power consumption caused by heating. However, for a resonator operating in a high-temperature environment, a higher TCF turnover point temperature is preferred. Therefore, in a design phase of a resonator, a TCF is expected to be adjustable to customize the TCF.

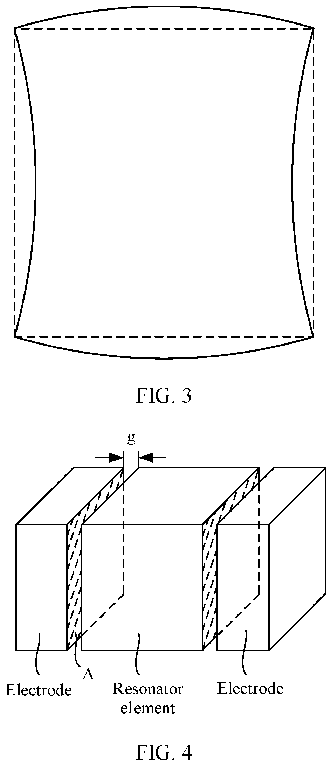

When a vibration mode of an existing conventional resonator, such as a square plate resonator, is a Lamé mode, a Q value is high, Rm is high, and a TCF turnover point temperature is also high. The Lamé mode, whose Chinese name is the 拉梅模态, may also be referred to as a square Lamé mode, and may be understood as a vibration mode in which a volume does not change in vibration. For example, two opposite sides of a square plate resonator in vibration are in in-phase vibration, and two adjacent sides are in anti-phase vibration. For example, in vibration, a left side and a right side of the resonator extend, and an upper side and a lower side contract, an extension amount is basically equal to a contraction amount, and a volume of the resonator does not change. Refer to FIG. 2 and FIG. 3. Dashed lines in FIG. 2 and FIG. 3 indicate forms of the square plate resonator not in vibration, and solid lines indicate forms of the square plate resonator in vibration. FIG. 2 is a diagram of the square plate resonator whose left portion and right portion perform extension vibration and upper portion and lower portion perform contraction vibration. FIG. 3 is a diagram of the square plate resonator whose left portion and right portion perform contraction vibration and upper portion and lower portion perform extension vibration. The square plate resonator in vibration repeatedly changes between the forms shown in FIG. 2 and FIG. 3.

For another example, when a vibration mode of a ring-shaped resonator is a breathing mode, the ring-shaped resonator has low Rm, a low Q value, and a low TCF turnover point temperature. The breathing mode may be understood as that synchronous vibration is performed at all positions in vibration. For example, the ring-shaped resonator in vibration synchronously extends or contracts at all the position.

It can be seen that a conventional resonator may have both a high Q value and high Rm, or have both low Rm and a low Q value, and it is difficult to balance a Q value and Rm.

This embodiment provides a resonator. A Q value of the resonator is high, and Rm is low, so that the Q value and Rm can be balanced. In addition, a TCF turnover point temperature of the resonator in this embodiment may be customized. For example, in a design phase of the resonator, the TCF turnover point temperature is adjusted based on an operating environment temperature of the resonator, so that the TCF turnover point temperature of the resonator matches the operating environment temperature of the resonator.

In this embodiment, the Q value and Rm of the resonator are mainly adjusted from perspectives of factors affecting the Q value and Rm.

For the actors affecting the Q value of the resonator, the resonator is an MEMS resonator, and the Q value is a measure of an energy loss of the MEMS resonator, that is, a smaller energy loss indicates a larger Q value. An energy loss mechanism of the MEMS resonator mainly includes five parts: Q corresponding to an air damping loss ($Q_{air}$ for short), Q corresponding to thermoelastic dissipation ($Q_{TED}$ for short), Q corresponding to a material loss ($Q_{material}$ for short), Q corresponding to an anchor loss ($Q_{anchor}$ for short), and Q corresponding to an electrical load loss ($Q_{load}$ for short). A total Q value of the MEMS resonator is a result of combined action of the energy loss mechanism. Refer to Formula 1.

$$\frac{1}{Q} = \frac{1}{Q_{air}} + \frac{1}{Q_{TED}} + \frac{1}{Q_{material}} + \frac{1}{Q_{anchor}} + \frac{1}{Q_{load}} \quad \text{Formula 1}$$

The loss is negatively correlated with Q corresponding to the loss. For example, if the loss is large, Q corresponding to the loss is small; or if the loss is small, Q corresponding to the loss is large. For example, if the thermoelastic dissipation is small, $Q_{TED}$ is large, or if the anchor loss is small, $Q_{anchor}$ is large.

It can be seen that increasing $Q_{TED}$ by reducing the thermoelastic dissipation, increasing $Q_{anchor}$ by reducing the anchor loss, and the like can increase the Q value of the resonator.

For the factors affecting Rm of the resonator, refer to Formula 2. In Formula 2, g indicates a spacing between a resonator element and an electrode of the resonator. Refer to FIG. 4. A indicates a sensing area that is of an electrode and that faces a resonator element (that is, an area of a side that is of the electrode and that faces the resonator element). Refer to FIG. 4. Q indicates a Q value of the resonator. In FIG. 4, an electrostatic resonator is used as an example for description. For a piezoelectric resonator, Rm of the resonator can also be reduced by increasing an area of a side of an electrode layer.

$$Rm \propto \frac{g^4}{QgA^2} \quad \text{Formula 2}$$

It can be seen from Formula 2 that Rm can be reduced by increasing the sensing area A that is of the electrode and that faces the resonator element.

It can be seen from Formula 2 that Rm can also be reduced by reducing the spacing between the resonator element and the electrode. However, it is difficult to reduce Rm by reducing the spacing between the resonator element and the electrode. Because the spacing is implemented through etching, it is more difficult to implement a smaller spacing through etching. In this case, reducing the spacing is limited and challenging. In addition, the smaller spacing usually indicates more obvious nonlinear effect of the electrostatic resonator.

Further, Rm of the resonator is also correlated with an elastic coefficient of the resonator element. For example, Rm of the resonator is positively correlated with the elastic coefficient of the resonator element. A smaller elastic coefficient of the resonator element indicates smaller Rm of the resonator.

It can be seen from the foregoing that Rm of the resonator can be reduced by increasing the sensing area A of the electrode of the resonator and reducing the elasticity coefficient of the resonator element.

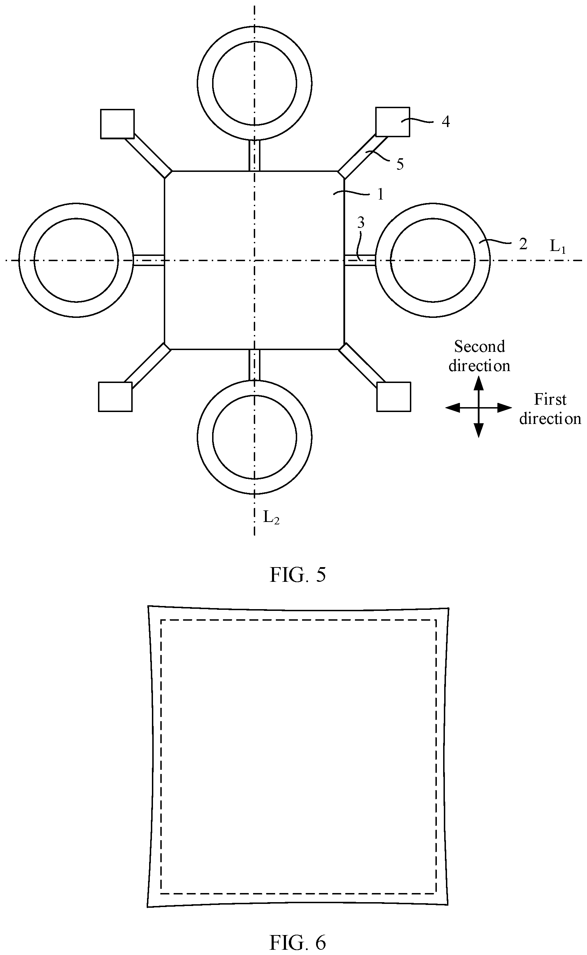

A resonator provided in this embodiment is a coupled resonator. As shown in FIG. 5, the resonator includes a first sub-resonator 1 and a plurality of second sub-resonators 2. The first sub-resonator 1 is connected to all the second sub-resonators 2. For example, the first sub-resonator 1 may be connected to any second sub-resonator 2 using a coupling rod 3. It should be noted that, to coupling the first sub-resonator 1 and all the second sub-resonators 2 into one resonator, correspondingly, a resonant frequency of the first sub-resonator 1 is equal to or approximately equal to a resonant frequency of any second sub-resonator 2, so that the first sub-resonator 1 can be coupled to all the second sub-resonators 2.

It should be noted that the resonant frequency of the first sub-resonator 1 is correlated with a vibration mode of the first sub-resonator 1. For example, the first sub-resonator 1 corresponds to one resonant frequency in a Lamé mode, and corresponds to another resonant frequency in an SE mode. Similarly, for the second sub-resonator 2, the resonant frequency of the second sub-resonator 2 is also correlated with a vibration mode of the second sub-resonator 2. In this case, the first sub-resonator 1 can be coupled to the second sub-resonators 2. For example, the first sub-resonator 1 in the Lamé mode can be coupled to the second sub-resonators 2 in a breathing mode, which may be understood as that the resonant frequency corresponding to the first sub-resonator 1 in the Lamé mode is equal to or approximately equal to resonant frequencies corresponding to the second sub-resonators 2 in the breathing mode.

When the first sub-resonator 1 and the second sub-resonator 2 are considered as independent resonators, a Q value of the first sub-resonator 1 and a Q value of the second sub-resonator 2 are referred to as intrinsic Q values, Rm of the first sub-resonator 1 and Rm of the second sub-resonator 2 are referred to as intrinsic Rm, and a TCF turnover point temperature of the first sub-resonator 1 and a TCF turnover point temperature of the second sub-resonator 2 are referred to as intrinsic TCF turnover point temperatures.

It should be noted that both a Q value and Rm of the resonator obtained after the first sub-resonator 1 is coupled to the plurality of second sub-resonators 2 are results obtained by combining those of the first sub-resonator 1 and the plurality of second sub-resonators 2, and are correlated with intrinsic features of the first sub-resonator 1 and the plurality of second sub-resonators 2, and proportions of the first sub-resonator 1 and each second sub-resonators 2 to the entire resonator.

In an example, the first sub-resonator 1 in vibration deforms in at least two non-parallel directions, and the first sub-resonator 1 is connected to the second sub-resonators 2 in all the at least two non-parallel directions. For example, the first sub-resonator 1 is connected to one second sub-resonator 2 in a positive direction and/or a negative direction of each direction. Deformations in all the at least two non-parallel directions are large, and couple the first sub-resonator 1 to the second sub-resonators 2. In this way, the first sub-resonator 1 is connected to one second sub-resonators 2 in a positive direction and/or a negative direction of each direction in which there is a deformation. If the first sub-resonator 1 is used as a driving component, the first sub-resonator 1 can drive a second sub-resonator 2 to vibrate in each direction in which there is a deformation, and be coupled to the second sub-resonator 2.

Deformation amounts in the at least two non-parallel directions are equal or approximately equal. For example, a difference between the deformation amounts is less than a deformation amount threshold. That the difference between the deformation amounts is less than the deformation amount threshold indicates that deformation amounts in the at least two non-parallel directions are close to each other, and the difference between the deformation amounts is small.

The first sub-resonator 1 in vibration deforms in the at least two non-parallel directions. For example, the first sub-resonator 1 in vibration can couple the first sub-resonator 1 to the second sub-resonators 2 in both a first direction (a horizontal direction) and a second direction (a vertical direction) shown in FIG. 5. Since deformations in both the directions can couple the first sub-resonator 1 to the second sub-resonators 2, it indicates that deformation amounts in both the directions are large. The deformation amounts in both the directions are large. Compared with that a deformation in one direction is large for coupling of the resonator, and a deformation in another direction is small and coupling of the resonator cannot be performed, this solution can reduce thermoelastic dissipation ($Q_{TED}$), so that the Q value of the resonator is increased according to Formula 1. Reasons are as follows:

Stress concentration is generated during vibration of the MEMS resonator, and causes a temperature gradient. As a result, an irreversible heat flow is generated and the thermoelastic dissipation is caused. The deformation amounts of the first sub-resonator 1 in the first direction and the second direction are large, or even equal or approximately equal while phases are opposite, so that a volume of the first sub-resonator is basically unchanged, and stress suffered by the first sub-resonator 1 is small. This can reduce unevenness of stress applied to all parts of the first sub-resonator 1 and can further reduce the temperature gradient, thereby reducing an energy loss and increasing the Q value.

In addition, the first sub-resonator 1 has the vibration deformations in the at least two directions, so that the first sub-resonator 1 can be connected to the second sub-resonators 2 in the at least two directions. For example, as shown in FIG. 5, the first sub-resonator 1 is connected to one second sub-resonator 2 separately in a positive direction and a negative direction of the first direction, and one second sub-resonator 2 separately in a positive direction and a negative direction of the second direction. In this way, the resonator includes a larger quantity of second sub-resonators 2, and the larger quantity of second sub-resonators 2 indicates a larger sensing area A in Formula 2, and smaller Rm. Therefore, increasing the quantity of second sub-resonators 2 can increase the sensing area A of electrodes, and reduce Rm of the coupled resonator.

It can be seen that for the resonator obtained after the first sub-resonator 1 is coupled to the plurality of second sub-resonators 2, the Q value of the coupled resonator can be increased via the first sub-resonator 1, Rm of the coupled resonator can be reduced based on the quantity of second sub-resonators 2. Then, the resonator balances the Q value and Rm, and can have a higher Q value and lower Rm.

In addition, a TCF turnover point temperature of the coupled resonator is between the intrinsic TCF turnover point temperature of the first sub-resonator 1 and the intrinsic TCF turnover point temperature of each second sub-resonator 2. In addition, the TCF turnover point temperature can be customized based on the vibration mode of the first sub-resonator 1, by adjusting a vibration mode of each second sub-resonator 2, by adjusting the quantity of second sub-resonators 2, and the like. The following describes factors affecting the TCF turnover point temperature of the coupled resonator.

The following describes features of the first sub-resonator 1 and the second sub-resonators 2.

(I) Vibration modes of the first sub-resonator 1 and the second sub-resonators 2

The vibration mode of the first sub-resonator 1 may be a bulk mode. In the bulk mode, an acoustic wave generated in vibration is a bulk acoustic wave, and the bulk acoustic wave is an acoustic wave propagated inside an object. The bulk acoustic wave includes a transverse wave and a longitudinal wave. The acoustic wave generated by the first sub-resonator 1 in vibration may be the transverse wave or the longitudinal wave. The transverse wave may also be referred to as a shear wave.

To increase an intrinsic Q value of the first sub-resonator 1, the acoustic wave generated by the first sub-resonator 1 in vibration may be the transverse wave. This is because during propagation of the transverse wave, a volume of the first sub-resonator 1 is basically unchanged, so that internal force is even, and a thermal gradient is small, resulting in small thermoelastic dissipation ($Q_{TED}$). In this case, according to Formula 1, a Q value is large. Therefore, the acoustic wave generated by the first sub-resonator 1 in vibration may be the transverse wave, to increase the intrinsic Q value of the first sub-resonator 1, thereby increasing a Q value of the resonator.

In an example, the vibration mode of the first sub-resonator 1 may be specifically one of a Lamé Lamé mode, a square extensional (square extensional, SE) mode, a face-shear (face-shear, FS) mode, a breathing mode, a wine glass (wine glass, WG) mode, and a width-shear (width-shear, WS) mode.

A bulk acoustic wave excited in the Lamé mode, the FS mode, the WS mode, and the WG mode is a transverse wave, and a bulk acoustic wave excited in the SE mode and the breathing mode is a longitudinal wave.

For the Lamé mode, refer to the foregoing descriptions. Two opposite sides of the resonator in the Lamé mode in vibration are in in-phase vibration, two adjacent sides are in anti-phase vibration, and a vibration node is at a vertex angle. In this case, the resonator in the Lamé mode deforms in two directions. As shown in FIG. 2 and FIG. 3, in vibration, deformations exist in both a length direction and a width direction with large deformation amounts, and can couple the first sub-resonator 1 to the second sub-resonators 2. As shown in FIG. 2 and FIG. 3, the deformation amounts in the length direction and the width direction are basically equal.

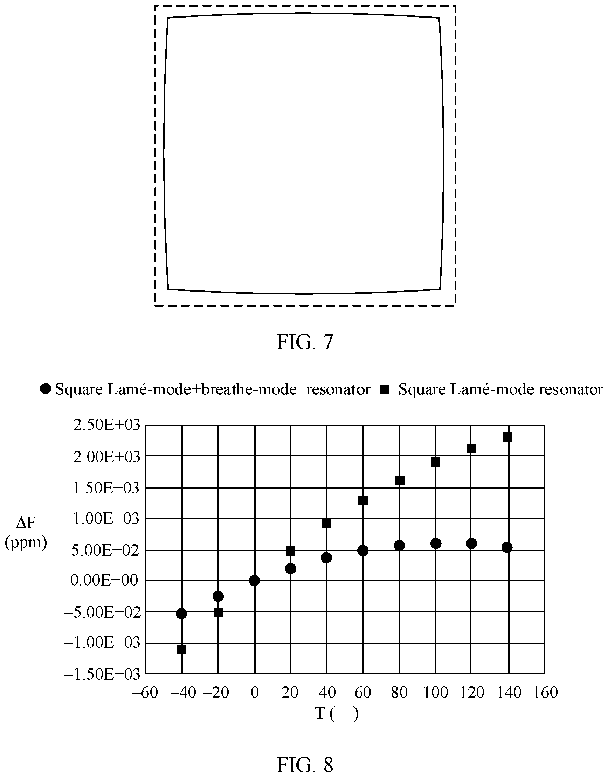

The SE mode may be understood as a vibration mode in which a volume changes in vibration. For example, in vibration, a left side and a right side of a square plate resonator extend, and an upper side and a lower side also extend; or the left side and the right side of the resonator contract, and the upper side and the lower side also contract, and a volume of the resonator changes. Refer to FIG. 6 and FIG. 7. Dashed lines in FIG. 6 and FIG. 7 indicate forms of the square plate resonator not in vibration, and solid lines indicate forms of the square plate resonator in vibration. FIG. 6 is a diagram of the square plate resonator performing extension vibration, and FIG. 7 is a diagram of the square plate resonator performing contraction vibration. The square plate resonator in vibration repeatedly changes between the forms shown in FIG. 6 and FIG. 7. The resonator in the SE mode in vibration deforms in two directions. As shown in FIG. 6 and FIG. 7, in vibration, deformations exist in both a length direction and a width direction with large deformation amounts, and can couple the first sub-resonator to the second sub-resonators. As shown in FIG. 6 and FIG. 7, the deformation amounts in the length direction and the width direction are close to each other and basically the same.

In the FS mode, for example, two vertex angle areas on a diagonal of the square plate first sub-resonator in vibration are in in-phase vibration, and two vertex angle areas not on a diagonal are in anti-phase vibration. For example, two vertex angle areas on a first diagonal are in in-phase vibration, two vertex angle areas on a second diagonal are in in-phase vibration, the vertex angle area on the first diagonal and the vertex angle area on the second diagonal are in anti-phase vibration, and a central position is a vibration node, that is, a position at which vibration is weakest.

The RB mode may be understood as that in-phase vibration is performed at all positions in vibration. For example, a disc-shaped resonator in vibration synchronously extends or contracts at all the positions.

Vibration of a square plate first sub-resonator in the WG mode is similar to that in the Lamé mode. For example, two opposite areas of a first sub-resonator in a circular disc shape in vibration are in in-phase vibration, two adjacent areas are in anti-phase vibration, and a vibration node of the first sub-resonator in vibration is a central position.

In the WS mode, for example, two vertex angle areas on a diagonal of a rectangle first sub-resonator in vibration are in anti-phase vibration, and two opposite areas located on a middle line of a long side are in anti-phase vibration. For example, one of two vertex angle areas on a first diagonal of the first sub-resonator in vibration extends, and the other contracts; one of two vertex angle areas on a second diagonal extends, and the other contracts; and one of the two areas located on the middle line of the long side extends, and the other contracts.

For ease of description, in this embodiment, the first sub-resonator 1 in the Lamé mode may be used as an example for description.

The vibration mode of the second sub-resonator 2 is one of a breathing mode, a Lamé Lamé mode, a square extensional SE mode, a face-shear FS mode, a wine glass WG mode, and a width-shear WS mode.

It should be noted that there are a plurality of second sub-resonators 2. Vibration modes of these second sub-resonators 2 may be the same, and are one of the breathing mode, the Lamé Lamé mode, the square extensional SE mode, the face-shear FS mode, the wine glass WG mode, and the width-shear WS mode. Alternatively, the vibration modes of these second sub-resonators 2 are not all the same, that is, vibration modes of some second sub-resonators 2 are the same, and vibration modes of some second sub-resonators 2 are different. For example, vibration modes of some second sub-resonators 2 are the breathing mode, vibration modes of some second sub-resonators 2 are the Lamé mode, and vibration modes of some second sub-resonators 2 are the SE mode.

In an example, the first sub-resonator 1 whose vibration mode is the Lamé mode is coupled to the second sub-resonator 2 whose vibration mode is the Lamé mode. The Lamé mode usually can excite a high Q value, so that a Q value of a coupled resonator can be significantly increased.

The breathing mode may include a ring-shaped breathing mode and a disc-shaped breathing mode. For ease of description, in this embodiment, unless otherwise specified, an example in which each second sub-resonator 2 is in the ring-shaped breathing mode may be used for description.

In an example, the vibration mode of the first sub-resonator 1 is the Lamé mode, and the resonator in the Lamé mode generally has a high Q value. In this case, after the first sub-resonator 1 is coupled to the second sub-resonators 2, a coupled resonator has a high Q value regardless of whether an intrinsic Q value of the second sub-resonator 2 is high or low. For example, if the intrinsic Q value of the second sub-resonator 2 is also high, the Q value of the coupled resonator is high, regardless of a proportion of the first sub-resonator 1 to the entire resonator. For another example, if the intrinsic Q value of the second sub-resonator 2 is not high, the Q value of the coupled resonator may be increased by increasing the proportion of the first sub-resonator 1 to the entire resonator and reducing a proportion of the second sub-resonator 2 to the entire resonator.

A square plate resonator with only the Lamé mode and a resonator obtained by coupling a square plate first sub-resonator in the Lamé mode to ring-shaped second sub-resonators in the breathing mode can be simulated. In a simulation result of the square plate resonator with only the Lamé mode, a Q value is $2e^6$, and Rm is 2 kohm. In a simulation result of the resonator obtained by coupling the square plate first sub-resonator in the Lamé mode to the ring-shaped second sub-resonators in the breathing mode, a Q value is $5e^5$, and Rm is 0.5 kohm. It can be seen that, the Q value in the simulation result is reduced but still large, and Rm is greatly reduced.

As shown in FIG. 8, frequency-temperature curves of the square plate resonator with only the Lamé mode and the resonator obtained by coupling the square plate first sub-resonator in the Lamé mode to the ring-shaped second sub-resonators in the breathing mode are compared. Compared with the square plate resonator with only the Lamé mode, a TCF turnover point temperature of the coupled resonator is significantly reduced. In this case, during application, the resonator can achieve good frequency stability when being heated to only about 110°C, thereby reducing power consumption caused by heating.

(II) Shapes of the first sub-resonator 1 and the second sub-resonators 2

The shape of the first sub-resonator 1 mainly indicates a shape of a resonator element of the first sub-resonator 1, and the shape of the second sub-resonator 2 mainly indicates a shape of a resonator element of the second sub-resonator 2.

In an example, the shape of the first sub-resonator 1 may be a plate shape, and whether the first sub-resonator 1 is specifically in a square plate shape, a rectangular plate shape, or a disc plate shape is mainly related to the vibration mode of the first sub-resonator 1.

For example, if the vibration mode of the first sub-resonator 1 is the Lamé mode, the SE mode, or the FS mode, the shape of the first sub-resonator 1 is usually a square plate shape. For another example, if the vibration mode of the first sub-resonator 1 is the WS mode, the shape of the first sub-resonator 1 is usually a rectangular plate shape. For another example, if the vibration mode of the first sub-resonator 1 is the WG mode, the shape of the first sub-resonator 1 is usually a disc plate shape, for example, a circular disc shape or an elliptic disc shape. For another example, if the vibration mode of the first sub-resonator 1 is a circular disc breathing mode in the breathing mode, the shape of the first sub-resonator 1 may be a circular disc plate shape or an elliptic disc plate shape.

In an example, the plate-shaped first sub-resonator 1 in vibration can deform in at least two non-parallel directions. For example, the first sub-resonator in vibration can deform in a left direction, a right direction, an upper direction, and a lower direction. These deformations can couple the first sub-resonator 1 to the second sub-resonators 2. In this case, a left side and a right side of the plate-shaped first sub-resonator 1 are separately connected to one second sub-resonator 2, and an upper side and a lower side of the plate-shaped first sub-resonator 1 are separately connected to one second sub-resonator 2. In this way, the plate-shaped first sub-resonator 1 is coupled to a larger quantity of second sub-resonators 2, and the larger quantity of second sub-resonators 2 can increase a sensing area to reduce Rm of the resonator.

In addition, deformations in the left direction and the right direction of the plate-shaped first sub-resonator 1 can couple the first sub-resonator 1 to the second sub-resonators 2, and deformations in the up direction and the down direction of the first sub-resonator 1 can couple the first sub-resonator 1 to the second sub-resonators 2. It indicates that deformation amounts in the left direction and the right direction of the first sub-resonator 1 and deformation amounts in the up direction and the down direction of the first sub-resonator 1 are large. For example, if the deformation amounts in the left direction and the right direction of the first sub-resonator 1 are equal or approximately equal to the deformation amounts in the up direction and the down direction of the first sub-resonator 1, a volume of the first sub-resonator 1 is basically unchanged, and stress suffered by the first sub-resonator 1 is small. This can reduce unevenness of stress applied to all parts of the first sub-resonator 1, and can further reduce a temperature gradient, thereby reducing an energy loss caused by heat transfer and increasing a Q value.

The shape of the second sub-resonator 2 is also related to the vibration mode of the second sub-resonator 2. For example, if the vibration mode of the second sub-resonator 2 is a ring-shaped breathing mode, the shape of the second sub-resonator 2 is usually a ring shape. The ring shape may be a regular ring or an irregular ring. The following describes the shape of the second sub-resonator 2 in detail, and the shape is briefly described herein. For another example, if the vibration mode of the second sub-resonator 2 is a disc-shaped breathing mode, the shape of the second sub-resonator 2 is usually a disc shape. The disc shape may be a regular disc shape or an irregular disc shape. The following describes the shape of the second sub-resonator 2 in detail, and the shape is briefly described herein.

(III) Position relationship between the first sub-resonator 1 and the second sub-resonators 2

In an example, the vibration mode of the first sub-resonator 1 is the Lamé mode, and a shape of the resonator in the Lamé mode is usually a square plate shape and is symmetric. Therefore, as shown in FIG. 5, the first sub-resonator 1 is symmetric. As shown in FIG. 5, the first sub-resonator 1 is in a square shape or is approximately in a square shape and has two symmetry axes: a symmetry axis $L_1$ and a symmetry axis $L_2$. The two symmetry axes are orthogonal to each other, and are middle lines of the first sub-resonator 1.

It should be noted that the symmetry axes of the first sub-resonator 1 are correlated with both the vibration mode and the shape of the first sub-resonator 1, and positions of the symmetry axes of the first sub-resonator 1 in the first sub-resonator 1 vary with the vibration mode. For example, the symmetry axes may be side midlines of the first sub-resonator 1, or may be diagonals of the first sub-resonator 1.

As shown in FIG. 5, all the second sub-resonators 2 are connected to the first sub-resonator 1, for example, through coupling rods 3. To avoid affecting the vibration mode of the first sub-resonator 1, two second sub-resonators 2 at two opposite sides of the first sub-resonator 1 are correspondingly symmetric about the symmetry axis of the first sub-resonator 1, and vibration modes of two second sub-resonators 2 in a same group are the same. In this case, there are at least four second sub-resonators 2, and every two second sub-resonators 2 form a group. The two second sub-resonators 2 in a same group are connected at two sides of the symmetry axis of the first sub-resonator 1, and are symmetric about the symmetry axis. The symmetry axis may be the symmetry axis $L_1$ or the symmetry axis $L_2$ in FIG. 5.

As described above, the vibration mode of the second sub-resonator 2 is one of the breathing mode, the Lamé mode, and the SE mode. For example, if there is one group of second sub-resonators 2, vibration modes of the second sub-resonators 2 in the group may be one of the foregoing vibration modes. For another example, if there are a plurality of groups of second sub-resonators 2, vibration modes of the plurality of groups of second sub-resonators 2 may be the same and may be one of the foregoing vibration modes; or the vibration modes of the plurality of groups of second sub-resonators 2 may be different, but vibration modes of second sub-resonators 2 in a same group are the same, to ensure symmetry without affecting the vibration mode of the first sub-resonator 1.

(IV) Quantity of second sub-resonators 2

In an example, the quantity of second sub-resonators 2 may be flexibly selected in a design phase of the resonator based on a desired Q value and desired Rm. For example, there are two second sub-resonators 2, one second sub-resonator 2 is located in one direction in which the first sub-resonator 1 deforms, and the other second sub-resonator 2 is located in another direction in which the first sub-resonator 1 deforms. For another example, the first sub-resonator 1 is symmetric, and there may be four second sub-resonators 2. Refer to FIG. 5. Every two second sub-resonators 2 in the four second sub-resonators 2 form a group. Two second sub-resonators 2 in a group of second sub-resonators 2 are distributed at two sides of the symmetry axis $L_1$ of the first sub-resonator 1, and symmetric about the symmetry axis $L_1$. Two second sub-resonators 2 in another group of second sub-resonators 2 are distributed at two sides of the symmetry axis $L_2$ of the first sub-resonator 1, and are symmetric about the symmetry axis $L_2$. The quantity of second sub-resonators 2 is not limited in this embodiment, and may be flexibly selected based on a design requirement. In this embodiment of this specification, four second sub-resonators 2 may be used as an example.

(V) Connection positions between the second sub-resonators 2 and the first sub-resonator 1 and connection position between a fastening anchor 4 and the first sub-resonator 1

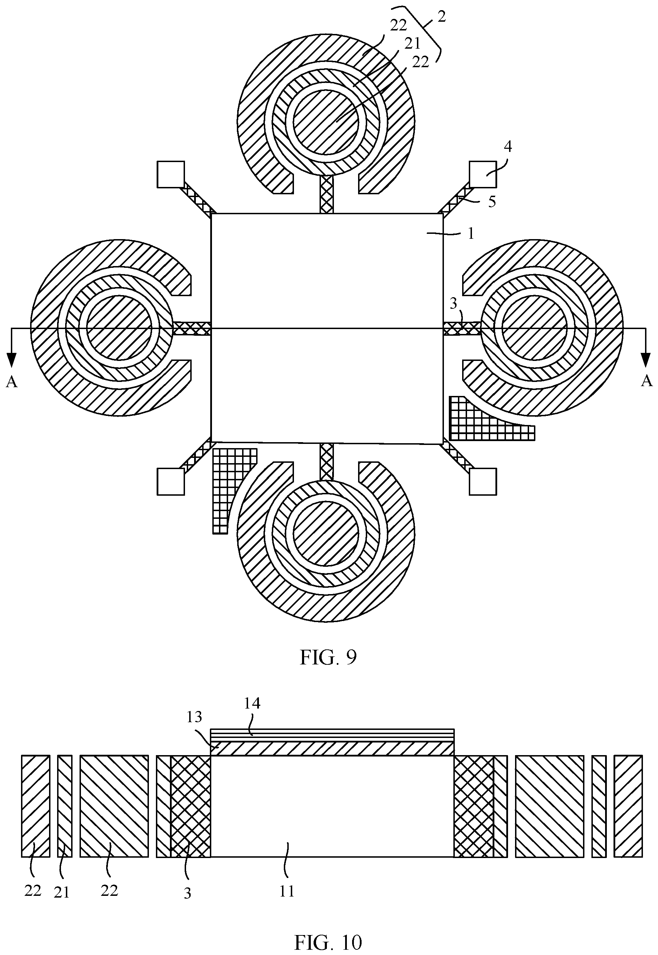

The connection positions between the second sub-resonators 2 and the first sub-resonator 1 may be flexibly selected, that is, each second sub-resonator 2 may be connected to any position of the first sub-resonator 1.
Unless otherwise specified, that the second sub-resonator 2 is connected to the first sub-resonator 1 indicates that a second resonator element 21 of the second sub-resonator 2 is connected to a first resonator element 11 of the first sub-resonator 1.
For better vibration transfer between the first sub-resonator 1 and the second sub-resonators 2, at least one second sub-resonator 2 may be correspondingly connected to a position that is of the first sub-resonator 1 and at which vibration is strongest. Each second sub-resonator may be connected to the position that is of the first sub-resonator 1 and at which vibration is strongest, or some second sub-resonators 2 each may be connected to the position that is of the first sub-resonator 1 and at which vibration is strongest. For example, if the vibration mode of the first sub-resonator 1 is the Lamé mode, the position that is of the first sub-resonator 1 and at which vibration is strongest may be a position of a side midpoint of the first sub-resonator 1. As shown in FIG. 5, at least one second sub-resonator 2 may be connected to a position of a midpoint of a side length of the first sub-resonator 1 through a coupling rod 3. For another example, if the vibration mode of the first sub-resonator 1 is the SE mode, the position that is of the first sub-resonator 1 and at which vibration is strongest may be a position of a vertex angle of the first sub-resonator 1. In this case, at least one second sub-resonator 2 may be connected to the position of the vertex angle of the first sub-resonator 1 through a coupling rod 3.
However, if the vibration mode of the first sub-resonator 1 is the SE mode, the second sub-resonator 1 may alternatively not be connected to the position that is of the first sub-resonator 1 and at which vibration is strongest, for example, may be connected to the position of the side midpoint of the first sub-resonator 1. The second sub-resonator 1 is connected to the position of the side midpoint of the first sub-resonator 1, so that the fastening anchor 4 may be connected to the position of the vertex angle of the first sub-resonator 1. In this way, it is convenient to arrange a first electrode 12 around the first resonator element 11 of the first sub-resonator 1 (refer to FIG. 9).
The foregoing describes the connection positions between the second sub-resonators 2 and the first sub-resonator 1, and the fastening anchor 4 is also connected to the first sub-resonator 1. In this case, for the connection position between the fastening anchor 4 and the first sub-resonator 1, refer to the following descriptions.
In an example, the resonator generates an electrical signal of a specific frequency through vibration. To avoid affecting vibration of the resonator, the resonator needs to be in a suspended state. For example, the MEMS resonator is suspended on a silicon wafer using a fastening anchor. As shown in FIG. 5, the fastening anchor 4 for fastening the resonator is connected to the first sub-resonator 1, so that the first sub-resonator 1 is in a suspended state with help of the fastening anchor 4, and the fastening anchor 4 interferes with vibration of the first sub-resonator 1, resulting in a specific anchor loss to the first sub-resonator 1. The plurality of second sub-resonators 2 around the first sub-resonator 1 are in a suspended state with help of the coupling rods 3, and the coupling rods 3 vibrate with the connected second sub-resonators 2, and basically do not interfere with vibration of the connected second sub-resonators 2. Therefore, there is almost no anchor loss to the second sub-resonators 2. According to Formula 1, a smaller anchor loss ($Q_{anchor}$) indicates a higher Q value of the resonator.
Therefore, the fastening anchor 4 for fastening the resonator is connected to only the first sub-resonator 1 and is not connected to the second sub-resonators 2, to effectively reduce anchor losses of the second sub-resonators 2 and further increase the Q value of the coupled resonator.

The connection position between the fastening anchor 4 and the first sub-resonator 1 may be flexibly selected, that is, the fastening anchor 4 may be connected to any position of the first sub-resonator 1.

Unless otherwise specified, that the fastening anchor 4 is connected to the first sub-resonator 1 indicates that the fastening anchor 4 is connected to the first resonator element 11 of the first sub-resonator 1.

To further reduce the anchor loss, correspondingly, the fastening anchor 4 may be connected to a position that is of the first sub-resonator 1 and at which vibration is weakest. The position at which vibration is weakest may also be referred to as a vibration node of the first sub-resonator 1. A vibration situation at each position of the first sub-resonator 1 may be tested through a simulation experiment. For example, if the vibration mode of the first sub-resonator 1 is the Lamé mode, as shown in FIG. 2 and FIG. 3, there is almost no vibration at the position of the vertex angle of the first sub-resonator 1. The position that is of the first sub-resonator 1 and at which vibration is weakest may be the position of the vertex angle of the first sub-resonator 1. In this case, the fastening anchor 4 may be connected to the position of the vertex angle of the first sub-resonator 1.

For another example, if the vibration mode of the first sub-resonator 1 is the SE mode, as shown in FIG. 6 and FIG. 7, vibration at the position of the side midpoint of the first sub-resonator 1 is weak, and the position that is of the first sub-resonator 1 and at which vibration is weakest may be the position of the side midpoint of the first sub-resonator 1. The fastening anchor 4 may be connected to the position of the side midpoint of the first sub-resonator 1.

For another example, if the vibration mode of the first sub-resonator 1 is the SE mode, the fastening anchor 4 may not be connected to the position that is of the first sub-resonator 1 and at which vibration is weakest. For example, the fastening anchor 4 may be connected to the position of the vertex angle of the first sub-resonator 1. Although vibration at the position of the vertex angle of the first sub-resonator 1 is strong, and an anchor loss is large, the anchor loss may be reduced by adjusting a connecting beam between the fastening anchor 4 and the first sub-resonator 1. The fastening anchor 4 may be connected to the position of the vertex angle of the first sub-resonator 1, so that it is convenient to arrange the first electrode 12 around the first resonator element 11 of the first sub-resonator 1 (refer to FIG. 9).

In an example, the first sub-resonator 1 may be connected to the fastening anchor 4 through a connecting beam 5. A specific shape of the connecting beam 5 may be a straight beam shown in FIG. 5. Alternatively, the connecting beam 5 may be a T-shaped beam. A horizontal portion of the T-shaped beam is connected to the fastening anchor 4, and a vertical portion of the T-shaped beam is connected to the first sub-resonator 1. Alternatively, a horizontal portion of the T-shaped beam is connected to the first sub-resonator 1, and a vertical portion of the T-shaped beam is connected to the fastening anchor 4. Alternatively, the connecting beam 5 may be a bent beam or the like. The specific shape of the connecting beam 5 is not limited in this embodiment, provided that the fastening anchor 4 can be connected to the first sub-resonator 1. A size of the connecting beam 5 should minimize a generated anchor loss, provided that a connection is achieved. A material of the connecting beam 5 may be the same as a material of the first sub-resonator 1, for example, may be a monocrystalline silicon material, or may be a doped monocrystalline silicon material.

(VI) Structure features included in the first sub-resonator 1 and the second sub-resonators 2

(1) The first sub-resonator 1 and the second sub-resonators 2 each include a resonator element, and the first sub-resonator 1 and/or at least one second sub-resonator 2 include/includes an electrode.

The first sub-resonator 1 and the second sub-resonators 2 each need resonance, and each include a resonator element. The resonator element of the first sub-resonator 1 may be denoted as a first resonator element 11, and a resonator element of the second sub-resonator 2 may be denoted as a second resonator element 21.

Whether the first sub-resonator 1 and the second sub-resonators 2 include an electrode is related to functions of the first sub-resonator 1 and the second sub-resonators 2. If the first sub-resonator 1 and the second sub-resonators 2 include a driving function and/or a detection function, the electrode is included. If the first sub-resonator 1 and the second sub-resonators 2 include neither a driving function nor a detection function, neither the first sub-resonator 1 nor the second sub-resonators 2 include the electrode. Details are as follows.

To excite vibration of the resonator, a drive signal needs to be imposed to the resonator. In a solution, the drive signal may be imposed to the first sub-resonator 1. In this way, the first sub-resonator 1 is used as an active vibration component, and all the second sub-resonators 2 are used as reactive vibration components. In another solution, the drive signal may also be imposed to a second sub-resonator 2. In this way, at least one second sub-resonator 2 is used as an active vibration component, and the first sub-resonator 1 is used as a reactive vibration component. Alternatively, in another solution, the drive signal is imposed to both the first sub-resonator 1 and the at least one second sub-resonator 2. In this way, both the first sub-resonator 1 and the second sub-resonator 2 to which the drive signal is imposed are used as active vibration components. Whether the drive signal is imposed to the first sub-resonator 1 or the at least one second sub-resonator 2 is not limited in this embodiment.

The resonator outputs a detection signal of a specific frequency. The detection signal may be output by the first sub-resonator 1, or may be output by at least one second sub-resonator 2, or may be output jointly by the first sub-resonator 1 and the at least one second sub-resonator 2. This is not limited in this embodiment.

Both inputting the drive signal and outputting the detection signal require an electrode. Therefore, if the first sub-resonator 1 is configured to impose the drive signal and/or output the detection signal, the first sub-resonator 1 needs to include an electrode. An electrode for inputting the drive signal is a drive electrode, the drive signal is for exciting vibration, and the drive electrode is connected to a power supply. An electrode for outputting the detection signal is a detection electrode, the detection signal is for detecting vibration, and the detection electrode is configured to connect to another component, for example, connect to an amplifier.

Similarly, if the second sub-resonator 2 is configured to impose the drive signal and/or output the detection signal, the second sub-resonator 2 needs to include an electrode. The electrode may be a drive electrode, or may be a detection electrode.

Certainly, if the first sub-resonator 1 or the second sub-resonator 2 is for neither driving nor detection, the electrode may be not included. However, it is not allowed that neither the first sub-resonator 1 nor the second sub-resonators 2 have the driving function, or neither the first sub-resonator 1 nor the second sub-resonators 2 have the detection function. In other words, in the first sub-resonator 1 and at least one second sub-resonator 2, there is a sub-resonator having the driving function, and there may be a sub-resonator having the detection function.

Based on the description, the first sub-resonator 1 includes a first resonator element 11 in a structure, and may include an electrode, or may not include an electrode. Similarly, each second sub-resonator 1 includes a second resonator element 21 in a structure, and may include an electrode, or may not include an electrode. The first sub-resonator 1 and all the second sub-resonators 2 each may include an electrode, but it is not allowed that neither the first sub-resonator nor all the second sub-resonators include an electrode.

For the first sub-resonator 1 and the second sub-resonator 2 that each include an electrode, a type of the first sub-resonator 1 and a type of the second sub-resonator 2 may be a piezoelectric resonator, or may be an electrostatic resonator.

A type of the first sub-resonator 1 may alternatively be a piezoelectric resonator. Refer to FIG. 9 and FIG. 10. A first sub-resonator 1 having the driving function and/or the detection function includes a first resonator element 11, a piezoelectric layer 13, and an upper electrode layer 14 that are sequentially stacked. In vibration, both the piezoelectric layer 13 and the upper electrode layer 14 vibrate with the first resonator element 11. If the piezoelectric first sub-resonator 1 does not include a lower electrode layer, the first resonator element 11 is used as both a base layer and a lower electrode layer. However, if the piezoelectric first sub-resonator 1 includes a lower electrode layer, the first resonator element 11 is used as only a base layer.

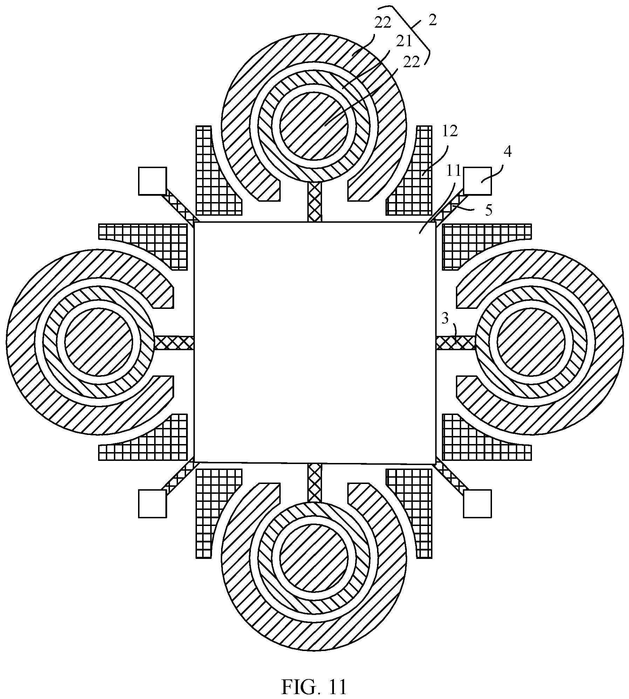

The first sub-resonator 1 may alternatively be an electrostatic resonator. As shown in FIG. 11, the first sub-resonator 1 having the driving function and/or the detection function includes a first resonator element 11 and a first electrode 12. The first electrode 12 is located around the first resonator element 11, and there is a spacing between the first resonator element 11 and the first electrode 12. In vibration, the first resonator element 11 vibrates, and the first electrode 12 does not vibrate with the first resonator element 11. The following describes a specific position relationship between the first resonator element 11 and the first electrode 12.

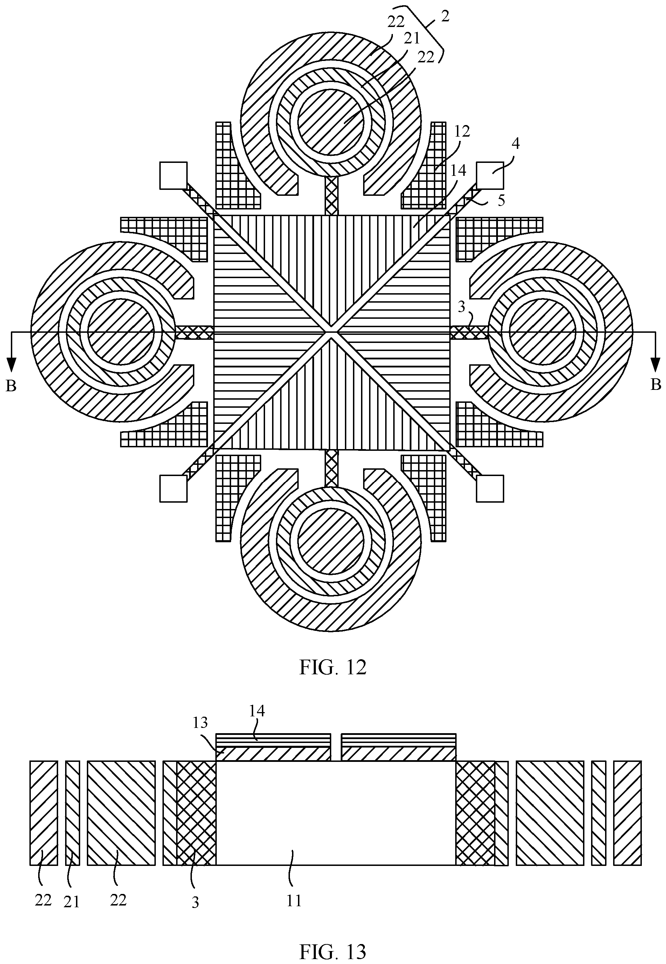

Alternatively, the first sub-resonator 1 may be a hybrid electrostatic and piezoelectric resonator. Refer to FIG. 12 and FIG. 13. A first sub-resonator 1 includes a first resonator element 11, a first electrode 12, a piezoelectric layer 13, and an upper electrode layer 14. The first electrode 12 is located around the first resonator element 11, and the piezoelectric layer 13 and the upper electrode layer 14 are sequentially stacked on a surface of the first resonator element 11. In this way, an electrostatic resonator is formed between the first electrode 12 and the first resonator element 11, and a piezoelectric resonator is formed between the first resonator element 11, the piezoelectric layer 13, and the upper electrode layer 14. The following describes the hybrid resonator in detail.

A type of the second sub-resonator 2 may be an electrostatic resonator. Refer to FIG. 12 and FIG. 13. A second sub-resonator 2 having the driving function and/or the detection function includes a second resonator element 21 and a second electrode 22.

Based on the description, there may be a plurality of selection manners for a drive electrode and a detection electrode of the resonator based on a specific structure form of the resonator, thereby improving selection flexibility. For example, the drive electrode may be an electrode of the first sub-resonator and/or an electrode of at least one second sub-resonator, and the detection electrode may also be an electrode of the first sub-resonator and/or an electrode of at least one second sub-resonator. Which electrode the drive electrode and the detection electrode are respectively is further related to a structure form of the resonator. For details, refer to the following.

That the second sub-resonator 2 includes the second electrode 22 as follows indicates that at least one of the plurality of second sub-resonators 2 includes the second electrode 22.

(i) A resonator includes a first sub-resonator 1 and a second sub-resonator 2. The first sub-resonator 1 is an electrostatic resonator and includes a first resonator element 11 and a first electrode 12, and the second sub-resonator 2 includes only a second resonator element 21.

In this structure form of the resonator, an electrode of the first sub-resonator 1 includes the first electrode 12, and the second sub-resonator 2 has no electrode. In this case, a drive electrode of the resonator may be the first electrode 12, and a detection electrode may also be the first electrode 12. For example, there are a plurality of first electrodes 12, some first electrodes 12 are used as drive electrodes, and the other first electrodes 12 are used as detection electrodes.

(ii) A resonator includes a first sub-resonator 1 and a second sub-resonator 2. The first sub-resonator 1 is a piezoelectric resonator and includes a first resonator element 11, a piezoelectric layer 13, and an upper electrode layer 14, and the second sub-resonator 2 includes only a second resonator element 21.

In this structure form of the resonator, an electrode of the first sub-resonator 1 includes the first resonator element 11 (used as a lower electrode layer) and the upper electrode layer 14, and the second sub-resonator 2 has no electrode. In this case, a drive electrode may be the first resonator element 11 and the upper electrode layer 14, and a detection electrode may also be the first resonator element 11 and the upper electrode layer 14. For example, in the first resonator element 11 and the upper electrode layer 14, one part is used as the drive electrode, and the other part is used as the detection electrode.

(iii) A resonator includes a first sub-resonator 1 and a second sub-resonator 2. The first sub-resonator 1 is a hybrid resonator and includes a first resonator element 11, a first electrode 12, a piezoelectric layer 13, and an upper electrode layer 14, and the second sub-resonator 2 includes only a second resonator element 21.

In this structure form of the resonator, an electrode of the first sub-resonator 1 includes the first resonator element 11 (as a lower electrode layer), the first electrode 12, and the upper electrode layer 14, and the second sub-resonator 2 has no electrode. In this case, a drive electrode may be the first resonator element 11, the first electrode 12, and the upper electrode layer 14, and a detection electrode may also be the first resonator element 11, the first electrode 12, and the upper electrode layer 14. For example, in the first resonator element 11, the first electrode 12, and the upper electrode layer 14, one part is used as the drive electrode, and the other part is used as the detection electrode.

(iv) A resonator includes a first sub-resonator 1 and a second sub-resonator 2. The first sub-resonator 1 includes only a first resonator element 11, and the second sub-resonator 2 includes a second resonator element 21 and a second electrode 22.

In this structure form of the resonator, the first sub-resonator 1 has no electrode, and the second sub-resonator 2 includes the second electrode 22. In this case, a drive electrode may be the second electrode 22, and a detection electrode may also be the second electrode 22. For example, there are a plurality of second electrodes 22, one part is used as the drive electrode, and the other part is used as the detection electrode.

(v) A resonator includes a first sub-resonator 1 and a second sub-resonator 2. The first sub-resonator 1 is an electrostatic resonator and includes a first resonator element 11 and a first electrode 12, and the second sub-resonator 2 includes a second resonator element 21 and a second electrode 22.

In this structure form of the resonator, an electrode of the first sub-resonator 1 includes the first electrode 12, and an electrode of the second sub-resonator 2 includes the second electrode 22. In this case, a drive electrode may be the first electrode 12 and the second electrode 22, and a detection electrode may also be the first electrode 12 and the second electrode 22. For example, in the first electrode 12 and the second electrode 22, one part is used as the drive electrode, and the other part is used as the detection electrode.

(vi) A resonator includes a first sub-resonator 1 and a second sub-resonator 2. The first sub-resonator 1 is a piezoelectric resonator and includes a first resonator element 11, a piezoelectric layer 13, and an upper electrode layer 14, and the second sub-resonator 2 includes a second resonator element 21 and a second electrode 22.

In this structure form of the resonator, an electrode of the first sub-resonator 1 includes the first resonator element 11 (as a lower electrode layer) and the upper electrode layer 14, and an electrode of the second sub-resonator 2 includes a second electrode 22. In this case, a drive electrode may be the first resonator element 11, the upper electrode layer 14, and the second electrode 22, and a detection electrode may be a first resonator element 11, an upper electrode layer 14, and a second electrode 22. For example, in the first resonator element 11, the upper electrode layer 14, and the second electrode 22, one part is used as the drive electrode, and the other part is used as the detection electrode.

(vii) A resonator includes a first sub-resonator 1 and a second sub-resonator 2. The first sub-resonator 1 is a hybrid resonator and includes a first resonator element 11, a first electrode 12, a piezoelectric layer 13, and an upper electrode layer 14, and the second sub-resonator 2 includes a second resonator element 21 and a second electrode 22.

In this structure form of the resonator, an electrode of the first sub-resonator 1 includes the first resonator element 11 (used as a lower electrode layer), the first electrode 12, and the upper electrode layer 14, and an electrode of the second sub-resonator 2 includes the second electrode 22. In this case, a drive electrode may be the first resonator element 11, the first electrode 12, the upper electrode layer 14, and the second electrode 22, and a detection electrode may also be the first resonator element 11, the first electrode 12, the upper electrode layer 14, and the second electrode 22. For example, in the first resonator element 11, the first electrode 12, the upper electrode layer 14, and the second electrode 22, one part is used as the drive electrode, and the other part is used as the detection electrode.

(2) The first sub-resonator 1 is an electrostatic resonator or a hybrid resonator, and a second sub-resonator 2 including a second electrode is an electrostatic resonator.

To obtain a resonator with a high Q value and low Rm, in this solution, the electrostatic resonator or the hybrid resonator may be selected as the first sub-resonator, and the electrostatic resonator may be selected as the second sub-resonator including a second electrode. This is explained as follows.

In a same condition, thermoelastic dissipation of the electrostatic resonator is usually lower than thermoelastic dissipation of the piezoelectric resonator. In this case, it can be seen from Formula 1 that a Q value of the electrostatic resonator is usually higher than a Q value of the piezoelectric resonator. Therefore, the electrostatic resonator or the hybrid resonator is selected as the first sub-resonator, and the electrostatic resonator is selected as the second sub-resonator 2 including the second electrode.

A reason why the thermoelastic dissipation of the electrostatic resonator is lower than that of the piezoelectric resonator is as follows.

Stress concentration is generated during vibration of the MEMS resonator. A temperature at a position at which the stress concentration is located is high while temperatures at other positions are low. As a result, a temperature gradient is caused. When there is the temperature gradient, heat transfer occurs, an irreversible heat flow is generated and leads to an energy loss, and the thermoelastic dissipation is generated.

A vibration component of the electrostatic resonator is a resonator element. The resonator element is of a single material. Internal vibration of the resonator element of the single material is similar, a strain field is weak, and stress concentration is not likely to occur. In this case, the thermoelastic dissipation of the resonator is small. However, a vibration component of the piezoelectric resonator is a stacked structure of a base layer, a piezoelectric layer, and an upper electrode layer. The vibration component is not of a single material, a strain field is strong, and stress concentration is likely to occur. In this case, the thermoelastic dissipation of the resonator is large. Therefore, because the vibration component of the electrostatic resonator is of a single material, and the vibration component of the piezoelectric resonator is of stacked materials, the thermoelastic dissipation of the electrostatic resonator is lower than that of the piezoelectric resonator. Then, according to Formula 1, in the same condition, for example, at a same resonant frequency, a Q value of the electrostatic resonator is usually higher than a Q value of the piezoelectric resonator.

In addition, for the electrostatic resonator, to further reduce the thermoelastic dissipation, a groove may be etched on a resonator element of the electrostatic resonator to isolate heat transfer between a hot end and a cold end caused by uneven stress, thereby reducing the heat flow and reducing the thermoelastic dissipation.

It should be noted that a method for reducing the thermoelastic dissipation by etching the groove on the resonator element of the electrostatic resonator is mostly applicable to a bending mode resonator with large thermoelastic dissipation, and is not applicable to a bulk mode resonator with small thermoelastic dissipation. This is because, for the bulk mode resonator with small thermoelastic dissipation, a temperature gradient distribution generated by local stress concentration caused by groove digging makes the thermoelastic dissipation exceed an original design level, resulting in a loss greater than a gain. Therefore, for the bulk mode resonator with small thermoelastic dissipation, a size in a crystal orientation may be adjusted based on Young's moduli of a resonator element in crystal orientations according to descriptions as follows, so that deformation amounts of the resonator element in vibration at all positions are equivalent, and stress at all the positions is evenly distributed. In this way, temperatures of the resonator element at all the positions are similar, and a temperature gradient is reduced, thereby reducing a heat flow, reducing an energy loss caused by the heat flow, reducing the thermoelastic dissipation, and increasing a Q value.

However, for the piezoelectric resonator with the stacked structure, heat transfer is in a vertical direction. To block the heat transfer, a groove needs to be etched in the vertical direction. It is difficult to etch the groove in the vertical direction, and etching the groove in the vertical direction causes the groove to block vibration of the piezoelectric layer to be transferred to the base layer, resulting in weak vibration and a large energy loss.

Therefore, in the same condition, for example, at the same resonant frequency, the Q value of the electrostatic resonator is usually higher than the Q value of the piezoelectric resonator.

However, it can be seen from Formula 2 that Rm of the electrostatic resonator is proportional to a spacing, and to obtain low Rm, the electrostatic resonator needs a spacing at a hundred nanometer level or even a level of dozens of nanometer. It is very difficult to implement an etching processing process. Therefore, Rm of the electrostatic resonator is usually several times or even several orders of magnitude greater than that of the piezoelectric resonator.

The first sub-resonator 1 is mainly configured to increase the Q value of the coupled resonator, and reducing Rm of the coupled resonator is mainly implemented based on a sensing area of the second sub-resonator 2, so both the first sub-resonator 1 and the second sub-resonator 2 may be electrostatic resonators.

Certainly, theoretically, the first sub-resonator 1 and the second sub-resonator 2 may alternatively be piezoelectric resonators. For ease of description, an example in which the first sub-resonator 1 is an electrostatic resonator or a hybrid resonator, and each second sub-resonator 2 is an electrostatic resonator may be used.

(3) The following describes structural features of an electrostatic first sub-resonator 1, a hybrid first sub-resonator 1, and electrostatic second sub-resonators 2.

(3.1) Arrangement relationship between a first resonator element 11 and a first electrode 12 of the first sub-resonator 1 that is an electrostatic resonator

Each second sub-resonator 2 is located at a side of the first sub-resonator 1, and in the electrostatic resonator, the first electrode 12 is also located at a side of the first resonator element 11. In this case, if the second sub-resonator 2 is not distributed at a side of the first resonator element 11 of the first sub-resonator 1, all positions of the side may be opposite to the first electrode 12. If the second sub-resonator 2 is distributed at a side of the first sub-resonator 1, as shown in FIG. 11, some positions of the side are opposite to the first electrode 12, and the other positions are connected to the second sub-resonator 2. For example, as shown in FIG. 11, if the second sub-resonator 2 is connected to a middle position of a side of the first resonator element 11 of the first sub-resonator 1, the first electrode 12 may be located at a position that is at the side of the first resonator element 11 and that is close to a vertex angle.

(3.2) Arrangement relationship between a first resonator element 11, a first electrode 12, a piezoelectric layer 13, and an upper electrode layer 14 of the first sub-resonator 1 that is a hybrid resonator

Refer to FIG. 12 and FIG. 13. The piezoelectric layer 13 and the upper electrode layer 14 may be sequentially laid on the first resonator element 11 of the first sub-resonator 1. For example, the piezoelectric layer 13 covers an upper surface of the first resonator element 11, and the upper electrode layer 14 covers an upper surface that is of the piezoelectric layer 13 and that is away from the first resonator element 11. The first resonator element 11 and the nearby first electrode 12 form an electrostatic resonator, and the first resonator element 11, the piezoelectric layer 13, and the upper electrode layer 14 are stacked to form a piezoelectric resonator. In this case, the first resonator element 11 is used as both a base layer of the piezoelectric resonator and a lower electrode layer of the piezoelectric resonator.

If a vibration mode of the first resonator element 11 is the SE mode, the vibration types of the first resonator element 11 in vibration in all areas are the same. The vibration types include extension vibration and contraction vibration. The vibration types in all the areas are the same. Refer to FIG. 6 and FIG. 7. The first resonator element 11 performs either extension vibration or contraction vibration in all the areas. It is impossible that the first resonator element 11 performs extension vibration in some areas and contraction vibration in the other areas. In this case, a shape of the piezoelectric layer 13 may be the same as a shape of the first resonator element 11. For example, both the piezoelectric layer 13 and the first resonator element 11 are in a square plate shape. The piezoelectric layer 13 is laid on the surface of the first resonator element 11. A shape of the upper electrode layer 14 is the same as the shape of the piezoelectric layer 13, and the upper electrode layer 14 is laid on the surface of the piezoelectric layer 13.

If the first resonator element 11 in vibration includes a plurality of vibration types, for example, a vibration mode of the first sub-resonator is the Lamé mode, the FS mode, the WS mode, or the WG mode, the vibration types of the first resonator element 11 in vibration in all the areas are different. Refer to FIG. 2 and FIG. 3. The first resonator element 11 in vibration performs extension vibration in some areas and contraction vibration in some areas. In this case, extension vibration and contraction vibration cannot be both included in an area of the first resonator element 11 covered by a same piezoelectric layer 13. This is because an electric charge generated by the piezoelectric layer 13 due to the extension vibration and an electric charge generated by the piezoelectric layer 13 due to the contraction vibration have opposite electrical properties, resulting in neutralization of the electric charges of the piezoelectric layer 13 and loss of piezoelectric effect. Therefore, vibration types of areas that are of the first resonator element 11 and that are covered by a same piezoelectric layer 13 are the same. In addition, to enhance the piezoelectric effect, correspondingly, a plurality of piezoelectric layers 13 may be selected based on the vibration types of the first resonator element 11 in all the areas. Each piezoelectric layer 13 covers the surface of the first resonator element 11, and vibration types in a covered area are the same. An upper surface of each piezoelectric layer 13 needs to be covered by an upper electrode layer 14. In this case, there are the plurality of upper electrode layers 14, and a surface that is of each piezoelectric layer 13 and that is away from the first resonator element 11 is covered by an upper electrode layer 14. When there are the plurality of piezoelectric layers 13, to avoid affecting vibration of two adjacent piezoelectric layers 13, correspondingly, there is a spacing between the two adjacent piezoelectric layers 13, and there is also a spacing between two adjacent upper electrode layers 14.

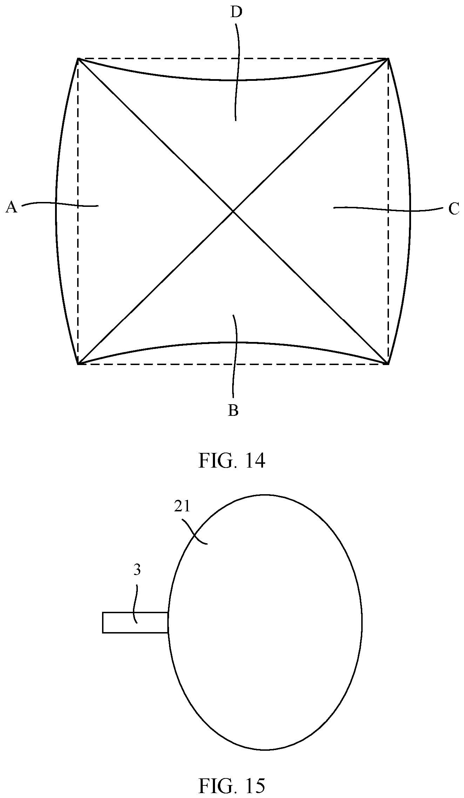

In a solution in which the vibration mode of the first resonator element 11 is the Lamé mode, the first resonator element 11 may be grouped into a plurality of areas based on vibration types of the first resonator element 11. Refer to FIG. 14. The first resonator element 11 may be grouped into four areas. A vibration type in an area A is the same as that of an area C, and a vibration type of an area B is the same as that of an area D. In this case, a same piezoelectric layer 13 may cover the area A and the area C, and a same piezoelectric layer 13 may cover the area B and the area D. In this case, there may be two piezoelectric layers 13, one piezoelectric layer 13 covers the area A and the area C, the other piezoelectric layer 13 covers the area B and the area D, and there are also two upper electrode layers 14, respectively covering the two piezoelectric layers 13. Alternatively, there may be four piezoelectric layers 13, and the four piezoelectric layers 13 respectively cover surfaces of the area A, the area B, the area C, and the area D. There are also four upper electrode layers 14, and the four upper electrode layers 14 respectively cover surfaces of the four piezoelectric layers 13. Refer to FIG. 12 and FIG. 13.

A shape of the piezoelectric layer 13 may be a triangle shape or an approximate triangle shape, or may be a trapezoid shape or an approximate trapezoid shape based on shapes of the area A, the area B, the area C, and the area D. The triangle-shaped piezoelectric layer 13 has a larger contact area with all the areas, and the larger contact area indicates higher piezoelectric effect of the piezoelectric layer 13 and better vibration effect.

The first sub-resonator includes the first electrode 12, the piezoelectric layer 13, and the upper electrode layer 14, for the first electrode 12 and the first resonator element 11 to form the electrostatic resonator, to increase an intrinsic Q value of the first sub-resonator, and increase the Q value of the resonator. The first resonator element 11, the piezoelectric layer 13, and the upper electrode layer 14 form the piezoelectric resonator. If the upper electrode layer 14 is used as a detection electrode, detection signal strength can be increased. If the upper electrode layer 14 is used as a drive electrode, drive signal strength can be increased. In addition, the detection electrode of the resonator may be selected from the first electrode 12, the upper electrode layer 14, and a second electrode 22, and the drive electrode may also be selected from the first electrode 12, the upper electrode layer 14, and the second electrode 22, thereby improving flexibility. It should be noted that a same electrode cannot be used as both the detection electrode and the drive electrode.

In addition, in a same condition, for example, at a same resonant frequency, Rm of a piezoelectric resonator is usually lower than Rm of an electrostatic resonator. Therefore, the first resonator element 11, the piezoelectric layer 13, and the upper electrode layer 14 form the piezoelectric resonator, helping reduce Rm of the resonator.

(3.3) Arrangement relationship between a second resonator element 21 and a second electrode 22 of the second sub-resonator 2 that is an electrostatic resonator

The arrangement relationship between the second resonator element 21 and the second electrode 22 in the second sub-resonator 2 is related to a shape of the second resonator element 21.

A shape of the following second resonator element 21 may be shapes of second resonator elements 21 of all second sub-resonators 2, or may be shapes of the second resonator elements 21 of some second sub-resonators 2 in all the second sub-resonators 2.

In an example, when a vibration mode of the second sub-resonator 21 is a ring-shaped breathing mode, the shape of the second resonator element 21 may be a ring shape. In this case, the second electrode 22 may be distributed inside or outside a ring of the second resonator element 21, or may be distributed in both inside and outside the ring.

The second electrode 22 is distributed inside the ring of the second resonator element 21, and the second electrode 22 may be in a column shape or may be in a ring shape.

If the second electrode 22 is distributed outside the ring of the second resonator element 21, the second electrode 22 is in a ring shape.

The second electrode 22 is distributed both inside and outside the ring. As shown in FIG. 11, the second electrode 22 inside the ring has a sensing area relative to the second resonator element 21, and the second electrode 22 outside the ring also has a sensing area relative to the second resonator element 21. This can greatly increase the sensing area, thereby reducing intrinsic Rm of the second resonator element 21, and reducing Rm of the resonator.

In another example, when a vibration mode of the second sub-resonator 2 is a disc-shaped breathing mode, the shape of the second resonator element 21 may be a disc shape, and the second electrode 22 is distributed outside a disc and in a disc circumferential direction. The disc shape may be a circular disc shape, or may be an elliptic disc shape shown in FIG. 15.

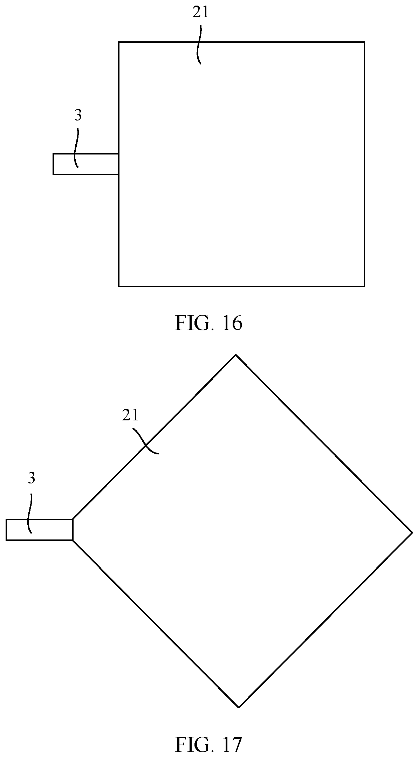

In another example, if a vibration mode of the second sub-resonator 2 is the Lamé mode, the shape of the second resonator element 21 may be a square plate shape. Refer to FIG. 16, a position of a midpoint of a side of the second resonator element 21 is connected to the first sub-resonator 1 through a coupling rod 3, and the first sub-resonator 1 is not shown in FIG. 16. The second electrode 22 of the square plate second resonator element 21 and are in a square ring shape, and are sleeved outside the second resonator element 21.

In another example, a vibration mode of the second sub-resonator 2 is the SE mode. As shown in FIG. 17, the second resonator element 21 is in a square shape, and a position of a vertex angle of the second resonator element 21 is connected to the first sub-resonator 1 through a coupling rod 3. The first sub-resonator 1 is not shown in FIG. 17. The second electrode 22 of the square plate second resonator element 21 and are in a square ring shape, and are sleeved outside the second resonator element 21.

(3.4) Features of a second resonator element 21 that is of a second sub-resonator 2 and that is in a ring shape or a disc shape

When a shape of the second resonator element 21 is the ring shape or the disc shape, the second resonator element 21 may be in a regular ring shape or a regular disc shape, or may be in an irregular ring shape or an irregular disc shape.

For example, an outer sidewall of the second resonator element 21 may have a plurality of curvature radii, so that the second resonator element 21 has oriented crystallinity. After the second resonator element 21 has the oriented crystallinity, a TCF turnover point temperature of the resonator may be adjusted by adjusting a relationship between a crystal orientation of the second sub-resonator 2 and a crystal orientation of a wafer in which the second sub-resonator 2 is located.

For the ring-shaped second resonator element 21, after the second resonator element 21 has the plurality of curvature radii outside the ring, a ring-shaped breathing mode may be affected. To enhance the ring-shaped breathing mode, an annulus width of the ring-shaped second resonator element 21 may be adjusted.

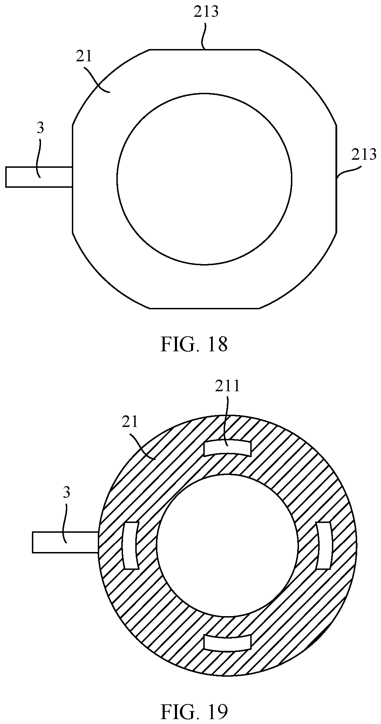

Infinitely large curvature radii indicate better oriented crystallinity of the second resonator element 21. In this case, the outer sidewall of the second resonator element 21 may have a cut-off face 213. For example, as shown in FIG. 18, a side wall outside the ring of the ring-shaped second resonator element 21 has the cut-off face 213. For another example, an outer sidewall of the disc-shaped second resonator element 21 has a cut-off face.

It should be noted that the outer sidewall of the second resonator element 21 has the plurality of curvature radii, so that the oriented crystallinity of the second sub-resonator 2 is implemented. If the shape of the second resonator element 21 is the ring shape, when the second resonator element 21 has a plurality of curvature radii inside the ring, the crystal orientation of the second sub-resonator 2 may also be implemented.

In another example, the ring-shaped or disc-shaped second resonator element 21 has a through-hole 211 running through a thickness direction. There may be a plurality of through-holes 211, and the plurality of through-holes 211 are evenly arranged in a circumferential direction. Refer to FIG. 19. The through-hole 211 in the second resonator element 21 can reduce stiffness of the second resonator element 21. Once the stiffness of the second resonator element 21 is reduced, an elastic coefficient of a deformation of the second resonator element 21 is reduced. Rm of the resonator is also correlated, for example, positively correlated, with the elastic coefficient. In this case, intrinsic Rm of the second sub-resonator 2 is reduced, thereby reducing Rm of the resonator.

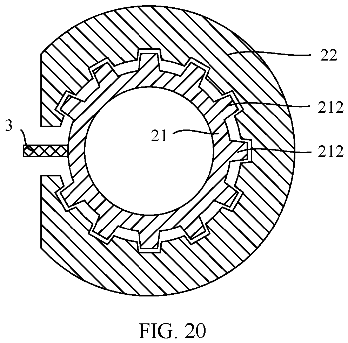

As shown in FIG. 20, the outer sidewall of the ring-shaped or disc-shaped second resonator element 21 has a protrusion 212. There may be a plurality of protrusions 212, and the plurality of protrusions 212 are evenly arranged in a circumferential direction. The second electrode 22 outside the ring of the ring-shaped second resonator element 21 matches the second resonator element 21. In this case, an inner side wall of the second electrode 22 has grooves. The protrusions 212 on the second resonator element 21 and the grooves of the second electrode 22 can increase a sensing area A of the second electrode 22. Once the sensing area A is increased, according to Formula 2, intrinsic Rm of the second sub-resonator 2 can be reduced, thereby reducing Rm of the resonator.

A specific shape of the second resonator element 21 of the second sub-resonator 2 is not limited in this embodiment. The shape of the second resonator element 21 may be flexibly selected in a design phase according to a Q value, Rm, and a TCF turnover point temperature required by the resonator. In this embodiment, a regular ring shape shown in FIG. 12 may be used as an example, because a second electrode 22 may be distributed both inside and outside the ring of the ring-shaped second resonator element 21 in the ring shape, to increase the sensing area and reduce intrinsic Rm of the second sub-resonator 2.

(4) The following describes sizes of a first sub-resonator 1 and a second sub-resonator 2, and a relationship between the sizes of the first sub-resonator 1 and the second sub-resonator 2.

In the description of the relationship of the sizes, the second sub-resonator 2 is each of all second sub-resonators 2 unless otherwise specified.

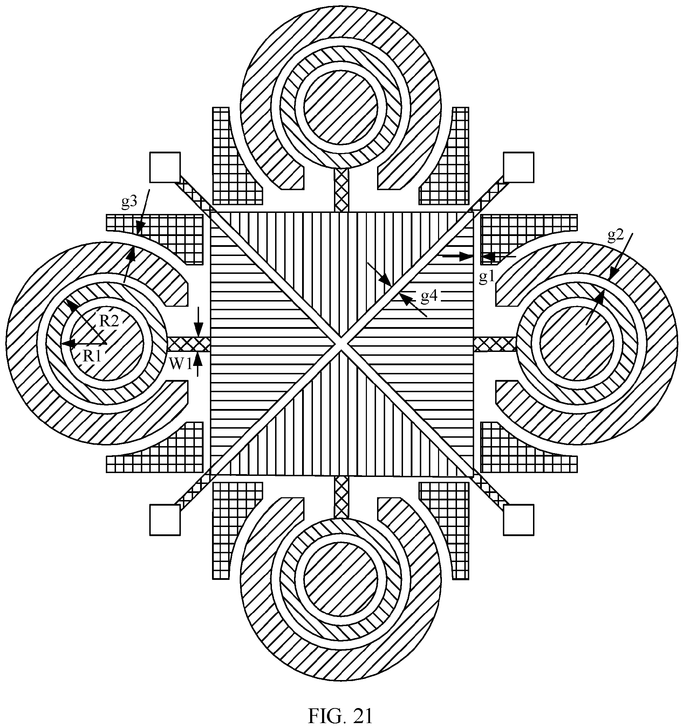

As described above, the first sub-resonator 1 is in a square shape or an approximate square shape. In this case, as shown in FIG. 21, two side lengths of a first resonator element 11 of the first sub-resonator 1 are equal or approximately equal. A thickness of the first resonator element 11 ranges from 10 $\mu$m to 100 $\mu$m. As shown in FIG. 13, thicknesses of the first resonator element 11 of the first sub-resonator 1 , a coupling rod 3, and a second resonator element 21 of the second sub-resonator 2 may be equal.

If the first sub-resonator 1 or the second sub-resonator 2 is a piezoelectric resonator, a thickness of a base layer of the piezoelectric resonator is greater than a thickness of a piezoelectric layer and greater than a thickness of an upper electrode layer. For example, the thickness of the base layer is more than 10 times the thickness of the piezoelectric layer.

As shown in FIG. 21, an inner radius of the second resonator element 21 of the ring-shaped second sub-resonator 2 is R1, an outer radius is R2, and a width of the coupling rod 3 is W1. In this case, a plane side length of the first resonator element 11 is greater than an annulus width (R2-R1) of the second resonator element 21 and greater than the width W1 of the coupling rod 3.

As described above, for an electrostatic resonator, a smaller spacing between a resonator element and an electrode indicates smaller intrinsic Rm of the electrostatic resonator. In this case, a spacing g1 between the first resonator element 11 and a first electrode 12 and a spacing g2 between the second resonator element 21 and a second electrode 22 may be minimized based on a capability of an etching process, where g1 and g2 may be equal, for example, less than 2 $\mu$m. Refer to FIG. 21.

As shown in FIG. 21, a spacing g3 between the first electrode 12 of the first sub-resonator 1 and the second electrode 22 of the second sub-resonator 2 that are close to each other needs to be greater, to avoid interference between the two electrodes. For example, g3 is greater than g1 and also greater than g2. For example, the first electrode 12 of the first sub-resonator 1 is a drive electrode, and the second electrode of the second sub-resonator 2 is a detection electrode. Because strength of a drive signal is greater than strength of a detection signal, if the spacing g3 between the electrode of the first sub-resonator 1 and the electrode of the second sub-resonator 2 is small, the drive signal interferes with the detection signal. Therefore, the spacing g3 between the electrode of the first sub-resonator 1 and the electrode of the second sub-resonator 2 may be minimized when interference is reduced to weakest, to reduce a size.

As described above, four triangle piezoelectric layers may be further laid on the first resonator element 11, and there is a spacing between two adjacent piezoelectric layers 13. Refer to FIG. 21. There is also a spacing between adjacent upper electrode layers 14, and the two spacings may be spacings g4, where g4 may be less than 10 $\mu$m.

(5) The following describes materials of a first sub-resonator 1 and a second sub-resonator 2.

In the description of the materials, the second sub-resonator 2 may be each of all second sub-resonators 2 unless otherwise specified.

This resonator may be an MEMS resonator, and the MEMS resonator is generally processed on a silicon wafer made of a monocrystalline silicon material. However, a crystal lattice inside the monocrystalline silicon material is regular, the material is pure, and thermoelastic dissipation is low. In this case, main materials of the first sub-resonator 1 and the second sub-resonator 2 may be monocrystalline silicon materials. For example, if the first sub-resonator 1 is an electrostatic resonator, a material of a resonator element of the first sub-resonator 1 is the monocrystalline silicon material; or if the first sub-resonator 1 is a piezoelectric resonator, a material of a base layer of the first sub-resonator 1 is the monocrystalline silicon material, a material of a piezoelectric layer may be aluminum nitride (AlN), aluminum scandium nitride (AlScN), lead zirconate titanate (PZT), lithium niobate (LiNbO3), and the like, and a material of an upper electrode layer may be conductive metal. Certainly, a material of the resonator may also be a doped monocrystalline silicon material. In this case, main materials of the first sub-resonator 1 and the second sub-resonator 2 may be doped monocrystalline silicon materials. For example, if the first sub-resonator 1 is an electrostatic resonator, a material of a resonator element of the first sub-resonator 1 is the doped monocrystalline silicon material. If the first sub-resonator 1 is a piezoelectric resonator, a base layer of the first sub-resonator 1 is the doped monocrystalline silicon material. The doped monocrystalline silicon material may be n-type doped or p-type doped. For example, a concentration of doped ions may be greater than $10^{19}$ cm$^{-3}$. For the resonator made of the doped monocrystalline silicon material, a TCF turnover point temperature can be adjusted by adjusting the concentration of doped ions in a design phase. The foregoing case is also applicable to the second sub-resonator 2.

In an example, a coupling rod 3 between the first sub-resonator 1 and the second sub-resonator 2 also vibrates as a vibration part of the coupled resonator. To reduce thermoelastic dissipation of the resonator, correspondingly, a material of the coupling rod 3 may also be the monocrystalline silicon material. Similarly, a material of a connecting rod between the first sub-resonator 1 and a fastening anchor 4 may also be the monocrystalline silicon material.

(VII) Customizable TCF turnover point temperature of the resonator

In the description of the customizable TCF turnover point temperature, unless otherwise specified, the second sub-resonator 2 may be each of all second sub-resonators 2.

For a resonator obtained by coupling the first sub-resonator 1 to a plurality of second sub-resonators 2, in a design phase, a Q value and Rm can be adjusted to achieve a high Q value and low Rm, and a TCF turnover point temperature of the coupled resonator can be customized.

For example, the TCF turnover point temperature of the resonator is correlated with at least one of the following parameters: a vibration mode of the first sub-resonator 1, a shape of the first sub-resonator 1, a material of the first sub-resonator 1, a vibration mode of the second sub-resonator 2, a shape of the second sub-resonator 2, a material of the second sub-resonator 2, a quantity of second sub-resonators 2, a relationship between a symmetry axis of the resonator and a crystal orientation of a wafer, and a relationship between a symmetry axis of the second sub-resonator 2 having oriented crystallinity and the crystal orientation of the wafer, where the wafer is a wafer in which the resonator is located, and the symmetry axis of the resonator is also a symmetry axis of the first sub-resonator 1.

The second sub-resonator 2 having the oriented crystallinity may be, for example, a ring-shaped second sub-resonator 2 having a cut-off face shown in FIG. 18.

In an example, in a design phase of the resonator, the TCF turnover point temperature may be adjusted by adjusting the vibration modes of the first sub-resonator 1 and the second sub-resonator 2. For example, if both the vibration modes of the first sub-resonator 1 and the second sub-resonator 2 are the Lamé mode, the TCF turnover point temperature of the coupled resonator is high. For another example, if the vibration mode of the first sub-resonator 1 is the Lamé mode, and the vibration mode of the second sub-resonator 2 is the breathing mode, the TCF turnover point temperature of the coupled resonator is between an intrinsic TCF turnover point temperature of the first sub-resonator 1 and an intrinsic TCF turnover point temperature of the second sub-resonator 2.

In another example, in a design phase of the resonator, the TCF turnover point temperature may be adjusted by adjusting a quantity of second sub-resonators 2. For example, a larger quantity of second sub-resonators 2 indicates that the TCF turnover point temperature of the coupled resonator is closer to the intrinsic TCF turnover point temperature of the second sub-resonator 2.

In another example, in a design phase of the resonator, the TCF turnover point temperature may be adjusted by adjusting a relationship between the symmetry axis of the first sub-resonator 1 and the crystal orientation of the wafer. For example, the TCF turnover point temperature of the coupled resonator is adjusted by adjusting an included angle relationship between the symmetry axis of the first sub-resonator 1 and the crystal orientation of the wafer. The following uses a <110> crystal orientation and a <100> crystal orientation of the silicon wafer as an example.

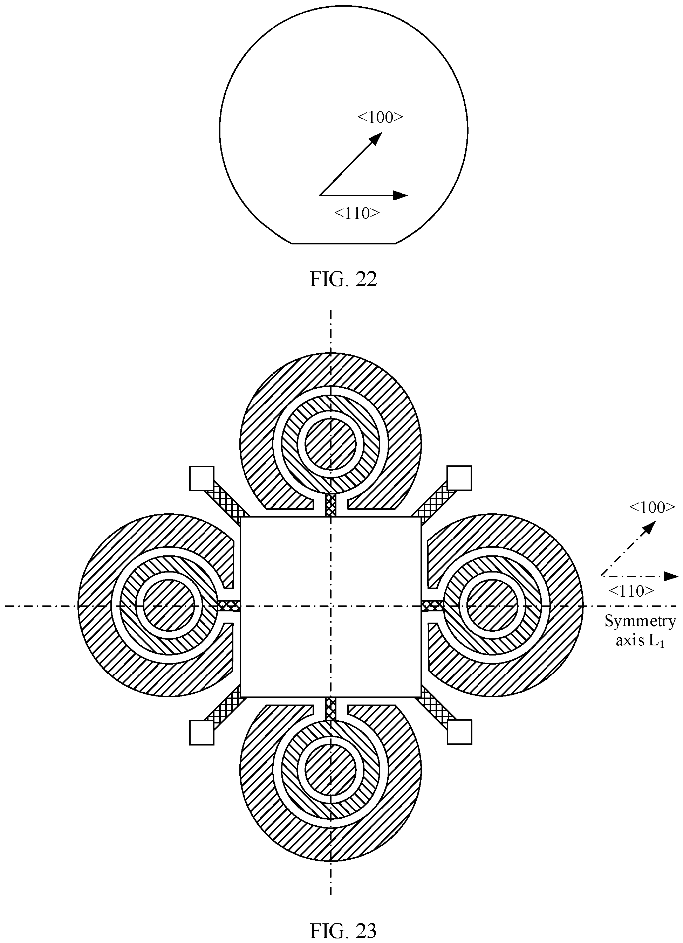

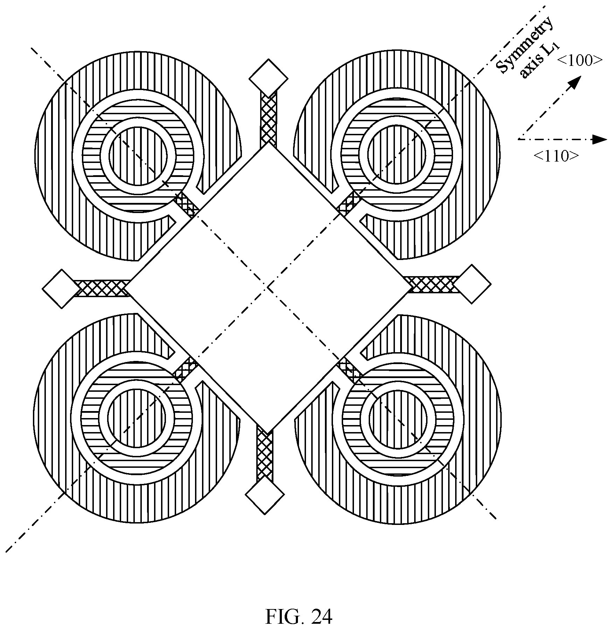

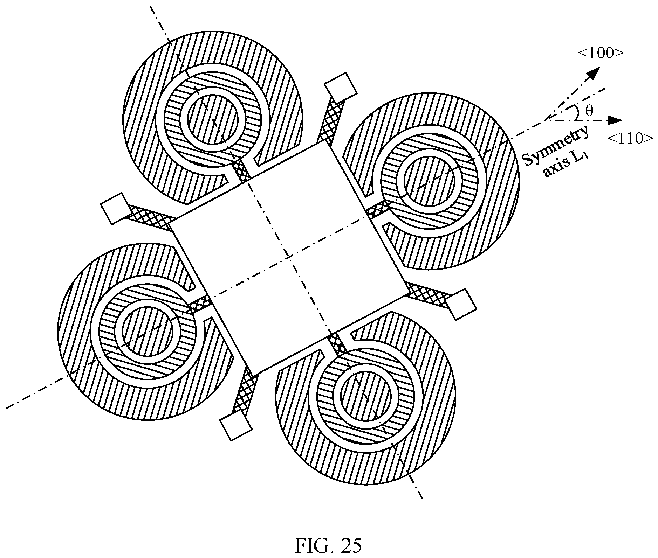

Refer to FIG. 22 and FIG. 23. The symmetry axis $L_1$ of the first sub-resonator 1 is in the <110> crystal orientation of the wafer, and the wafer is n-type doped. For example, the concentration of doped ions may be greater than $10^{19}$ cm$^{-3}$, and the coupled resonator has a lowest TCF turnover point temperature. FIG. 22 is a diagram of the <110> crystal orientation and the <100> crystal orientation of the wafer. As shown in FIG. 24, the symmetry axis $L_1$ of the first sub-resonator 1 is in the <100> crystal orientation of the wafer, and the wafer is n-type doped. The coupled resonator has a highest TCF turnover point temperature. As shown in FIG. 25, the symmetry axis $L_1$ of the first sub-resonator 1 is between the <110> crystal orientation and the <100> crystal orientation, and the coupled resonator has a moderate TCF turnover point temperature. It can be seen that the TCF turnover point temperature may be adjusted by adjusting the included angle $\theta$ to change the TCF turnover point temperature between the lowest TCF turnover point temperature and the highest TCF turnover point temperature. The included angle $\theta$ is an included angle between the symmetry axis $L_1$ and the <110> crystal orientation. Therefore, in the design phase of the resonator, a specific TCF turnover point temperature can be obtained by adjusting the position relationship between the geometric symmetry axis of the resonator and the crystal orientation of the silicon wafer.

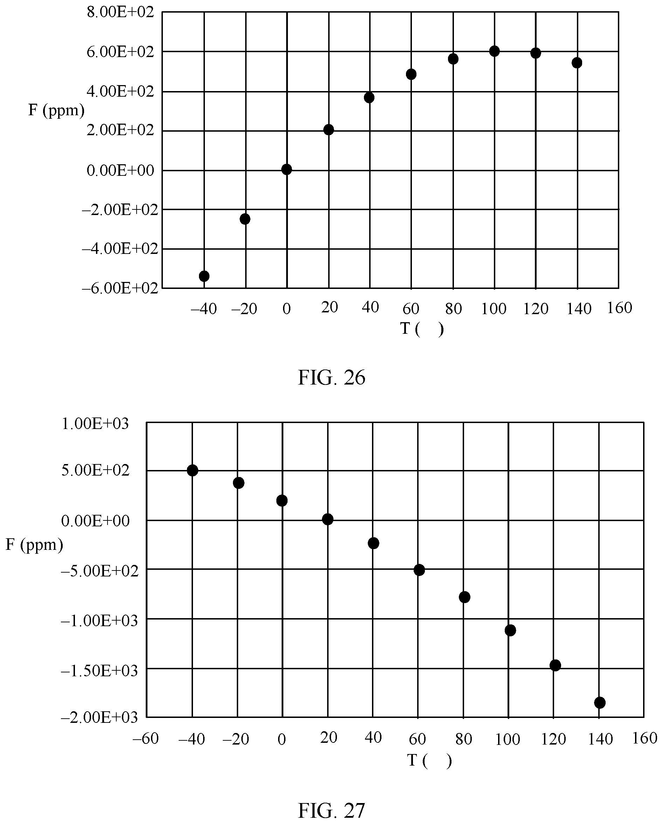

For a simulation result of adjusting the TCF turnover point temperature of the coupled resonator by adjusting the included angle relationship between the symmetry axis $L_1$ and the crystal orientation of the wafer, refer to FIG. 26 and FIG. 27. FIG. 26 is a simulation result of the TCF turnover point temperature of the resonator when the symmetry axis is in the <100> crystal orientation. FIG. 27 is a simulation result of the TCF turnover point temperature of the resonator when the symmetry axis is in the <110> crystal orientation. As shown in FIG. 26, if the symmetry axis is in the <100> crystal orientation, the TCF turnover point temperature of the resonator is around 110°C. As shown in FIG. 27, if the symmetry axis is in the <110> crystal orientation, the TCF turnover point temperature of the resonator is less than -40°C, showing a negative TCF. It can be seen that a specific TCF turnover point temperature can be obtained by adjusting the position relationship between the geometric symmetry axis of the resonator and the crystal orientation of the silicon wafer.

In this embodiment of this application, for the resonator obtained after the first sub-resonator is coupled to the plurality of second sub-resonators, the Q value of the coupled resonator can be increased via the first sub-resonator, Rm of the coupled resonator can be reduced based on the quantity of second sub-resonators. Then, the resonator balances the Q value and Rm, and can have a higher Q value and lower Rm.

In addition, the TCF turnover point temperature of the coupled resonator is between the intrinsic TCF turnover point temperature of the first sub-resonator 1 and intrinsic TCF turnover point temperatures of the plurality of second sub-resonators 2. In addition, the TCF turnover point temperature can be customized based on the vibration mode of the first sub-resonator 1, by adjusting the vibration mode of each second sub-resonator 2, by adjusting the quantity of second sub-resonators 2, and the like.

As described above, the size in the crystal orientation may be adjusted based on the Young's moduli of the resonator element in crystal orientations, so that deformation amounts of the resonator element in vibration in all crystal orientations tend to be equal, to further reduce the thermoelastic dissipation (thermoelastic dissipation, TED) and increase the Q value.

A mechanism for generating thermoelastic dissipation is as follows: A resonator element for vibration in a resonator is mostly made of a single crystal, the single crystal has an anisotropy feature, resulting in stiffness anisotropy of the resonant element, and due to the stiffness anisotropy of the resonant element, in resonance, stiffness in all crystal orientations is different. The stiffness may be indicated by a Young's modulus. A larger Young's modulus indicates stronger energy for resisting deformation, and larger stiffness. Therefore, in resonance, the stiffness of the resonator element in all the crystal orientations is different, that is, Young's moduli in all the crystal orientations are different.

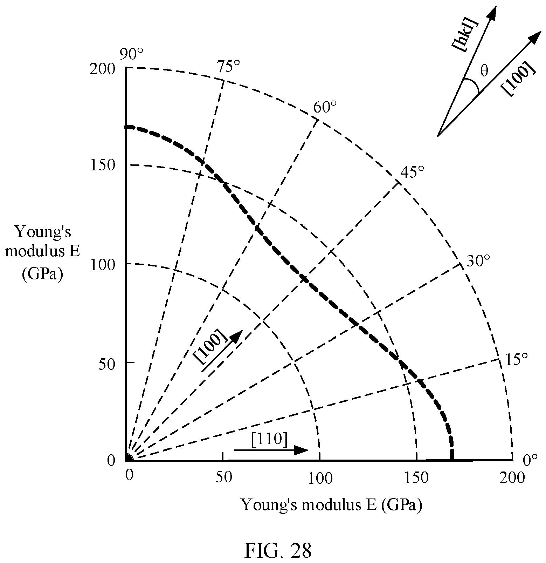

For example, FIG. 28 shows a relationship between a Young's modulus and a crystal orientation in a crystal plane (for example, a (100) crystal plane) of a monocrystalline silicon. It can be seen from FIG. 28 that different crystal orientations correspond to different Young's moduli, and a same crystal orientation corresponds to a same Young's modulus. It can be seen that a Young's modulus of the monocrystalline silicon in a [110] crystal orientation is largest and a Young's modulus of the monocrystalline silicon in a [100] crystal orientation is smallest.

It should be noted that a crystal is symmetric, and crystal orientations that are symmetrically related may have different directions, but have a same period, so the crystal orientations are equivalent and have equal Young's moduli. Therefore, two crystal orientations that are symmetrically related belong to an equivalent crystal orientation instead of different crystal orientations, and do not fall within the scope of the description that "different crystal orientations correspond to different Young's moduli".

However, the Young's moduli in all the crystal orientations are different, and consequently, deformation amounts of the resonant element in all the crystal orientations are different. In this case, heat generated by the resonant element in all the crystal orientations is different. In this way, a thermal gradient (which may also be referred to as a temperature gradient) is generated, the thermal gradient results in a heat flow, energy is consumed in the heat flow, this energy loss is an irreversible energy loss, and the loss is referred to as thermoelastic dissipation.

It can be seen from the foregoing that if the deformation amounts of the resonator element in vibration in all the crystal orientations are equal, the thermal gradient and the heat flow may be reduced, to reduce the thermoelastic dissipation.

A length of the resonator element on a straight line parallel to a crystal orientation may be increased, to compensate for a disadvantage that is of a small deformation amount in the crystal orientation and that is caused by a small Young's modulus corresponding to the crystal orientation. Similarly, the length of the resonator element on the straight line parallel to the crystal orientation may be reduced, to compensate for a disadvantage that is of a large deformation amount in the crystal orientation and that is caused by a large Young's modulus corresponding to the crystal orientation. The deformation amounts of the resonator element in different crystal orientations may be made almost the same based on this principle, to reduce the thermoelastic dissipation of the resonator element, and increase a Q value of a resonator in which the resonator element is located.

The length of the resonator element on the straight line parallel to the crystal orientation is related to a shape of the resonator element.

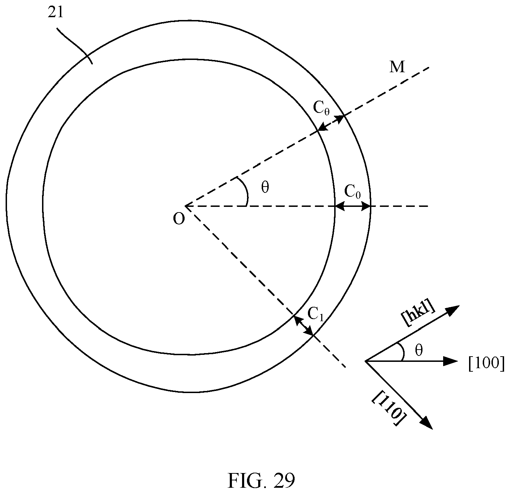

For example, if the shape of the resonator element is a ring shape, a length of the resonator element on a straight line parallel to a crystal orientation is an annulus width on the straight line. Refer to FIG. 29. A length of the resonator element on a straight line M parallel to a [hkl] crystal orientation is an annulus width on the straight line M, that is, Ce.

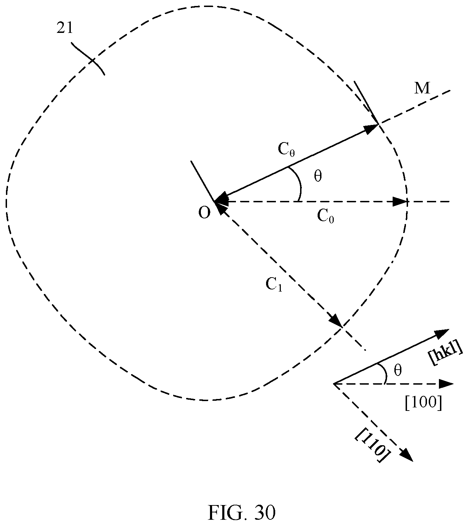

For another example, if the shape of the resonator element is a disc shape, a length of the resonator element on a straight line parallel to a crystal orientation is a radius on the straight line. Refer to FIG. 30. A length of the resonator element on a straight line M parallel to a [hkl] crystal orientation is a radius on the straight line M, that is, Ce.

Therefore, for an electrostatic resonator whose thermoelastic dissipation is low, for example, a bulk mode resonator in the electrostatic resonator, the thermoelastic dissipation may be further reduced according to the foregoing solution.

According to the foregoing analysis, a resonator in this embodiment includes a first sub-resonator 1 and a plurality of second sub-resonators 2. The first sub-resonator 1 may be a piezoelectric resonator, the second sub-resonators 2 may be electrostatic resonators, and the second sub-resonators 2 may be specifically bulk mode resonators in the electrostatic resonators. The first sub-resonator 1 includes a first resonator element 11, and the second sub-resonator 2 includes a second resonator element 21.

In this case, thermoelastic dissipation of the second sub-resonator 2 may be further reduced according to the foregoing solution. Correspondingly, in the following background, the second resonator element 21 of the second sub-resonator 2 has different Young's moduli in different target crystal orientations. The target crystal orientations are crystal orientations parallel to a plane in which the second resonator element 21 is located.

A length of the second resonator element 21 on any straight line is negatively correlated with a Young's modulus in any target crystal orientation.

The any straight line is a straight line that is parallel to the any target crystal orientation and that passes through a central position of the second resonator element 21.

In an example, if the second resonator element 21 has a larger Young's modulus in a target crystal orientation (denoted as a first target crystal orientation), during design of the second resonator element 21, a length of the second resonator element 21 may be smaller on a straight line (denoted as a first straight line) that is parallel to the first target crystal orientation and that passes through the central position of the second resonator element 21. In this way, a deformation amount of the second resonator element 21 in vibration in the first target crystal orientation is larger.

If the second resonator element 21 has a smaller Young's modulus in another target crystal orientation (denoted as a second target crystal orientation), during design of the second resonator element 21, a length of the second resonator element 21 may be larger on a straight line (denoted as a second straight line) that is parallel to the second target crystal orientation and that passes through the central position of the second resonator element 21. In this way, a deformation amount of the second resonator element 21 in vibration in the second target crystal orientation is smaller.

For example, if a material of the second resonator element 21 is monocrystalline silicon, as shown in FIG. 28, the first target crystal orientation may be a crystal orientation (for example, the [110] crystal orientation) in a <110> crystal orientation family, and the second target crystal orientation may be a crystal orientation (for example, the [100] crystal orientation) in a <100> crystal orientation family.

In this case, a length of the second resonator element 21 is smallest on a straight line that is parallel to the [110] crystal orientation and that passes through the central position, and a length of the second resonator element 21 is largest on a straight line that is parallel to the [100] crystal orientation and that passes through the central position.

In an example, if a shape of the second resonator element 21 is a circular ring shape, as shown in FIG. 29, a length (that is, an annulus width) $C_1$ of the second resonator element 21 is smallest on a straight line that is parallel to the [110] crystal orientation and that passes through the central position, and a length (that is, an annulus width) $C_0$ of the second resonator element 21 is largest on a straight line that is parallel to the [100] crystal orientation and that passes through the central position.

In another example, if a shape of the second resonator element 21 is a disc shape, as shown in FIG. 30, a length (that is, a radius) $C_1$ of the second resonator element 21 is smallest on a straight line that is parallel to the [110] crystal orientation and that passes through the central position, and a length (that is, a radius) $C_0$ of the second resonator element 21 is largest on a straight line that is parallel to the [100] crystal orientation and that passes through the central position.

In this way, deformation amounts of the second resonator element 21 in vibration in all the target crystal orientations are neither excessively large nor excessively small. In this way, the deformation amounts in all the target crystal orientations are equivalent. In this case, heat generated from deformations at all positions of the second resonator element 21 in vibration is similar, and a thermal gradient is small, and a heat flow is weak. In this case, energy consumed by the heat flow is also small, and thermoelastic dissipation is small.

In an example, as a result of stiffness anisotropy of the second resonator element 21, the second resonator element 21 of the second sub-resonator 2 has different Young's moduli in different target crystal orientations. The stiffness anisotropy of the second resonator element 21 is caused by anisotropy of the second resonator element 21, and the anisotropy is a property of a single crystal. Therefore, the material of the second resonator element 21 is a single crystal or a doped single crystal. For example, the material of the second resonator element 21 may be one of monocrystalline silicon, monocrystalline aluminum nitride, n-type doped single crystal, and p-type doped single crystal.

As described above, the length of the second resonator element 21 on the any straight line is negatively correlated with the Young's modulus in the any target crystal orientation. For example, a relationship between the length of the second resonator element 21 on the any straight line and the Young's modulus in the any target crystal orientation may satisfy the following Formula 3:

$$C(\theta) = \left( \frac{E_0}{E(\theta)} \right)^k \times C_0 \quad \text{Formula 3}$$

In Formula 3, $C(\theta)$ indicates a theoretical length of the second resonator element 21 on any straight line M. Refer to FIG. 29 and FIG. 30.

$E(\theta)$ indicates a Young's modulus of the second resonator element 21 in any target crystal orientation [hkl]. Refer to FIG. 28.

$\theta$ indicates an included angle between the any target crystal orientation [hkl] and a reference target crystal orientation of the second resonator element 21. Refer to FIG. 28. The reference target crystal orientation in FIG. 28 is [100].

$C_0$ indicates a length of the second resonator element (21) in the reference target crystal orientation. Refer to FIG. 29 and FIG. 30.

$E_0$ indicates a Young's modulus of the second resonator element 21 in the reference target crystal orientation. Refer to FIG. 28.

k is a constant greater than zero.

During design of the second resonator element 21, an actual length $C(\theta)$' of the second resonator element 21 on any straight line may fall within a range of plus or minus 0.05 $kC_0$ from $C(\theta)$ calculated according to Formula 3, for example, fall within a range of plus or minus 170 micrometers from calculated $C(\theta)$. Therefore, an absolute value of a difference between $C(\theta)$' and $C(\theta)$ is less than or equal to 0.05 $kC_0$. For example, an absolute value of a difference between $C(\theta)$' and $C(\theta)$ is less than or equal to 170 micrometers.

In an example, for the reference target crystal orientation, any one of a plurality of target crystal orientations may be selected as the reference. Certainly, for ease of calculation, a special target crystal orientation is generally selected as the reference. For example, a target crystal orientation corresponding to a smallest Young's modulus may be selected, or a target crystal orientation corresponding to a largest Young's modulus may be selected. Therefore, if the target crystal orientation corresponding to the smallest Young's modulus is selected as the reference crystal orientation, $E_0$ is less than $E(\theta)$.

For example, if a material of the second resonator element 21 is monocrystalline silicon, the [100] crystal orientation with a smallest Young's modulus may be selected as the reference crystal orientation.

In an example, if the shape of the second resonator element 21 is the ring shape, $C(\theta)$ may be the annulus width shown in FIG. 29. If the shape of the second resonator element 21 is the disc shape, $C(\theta)$ may be the radius shown in FIG. 30.

In an example, if the shape of the second resonator element 21 is the ring shape, and curvature radii at all positions inside and outside a ring of the second resonator element 21 are greater than zero, the value range of k may be greater than or equal to 0.3 and less than or equal to 0.8.

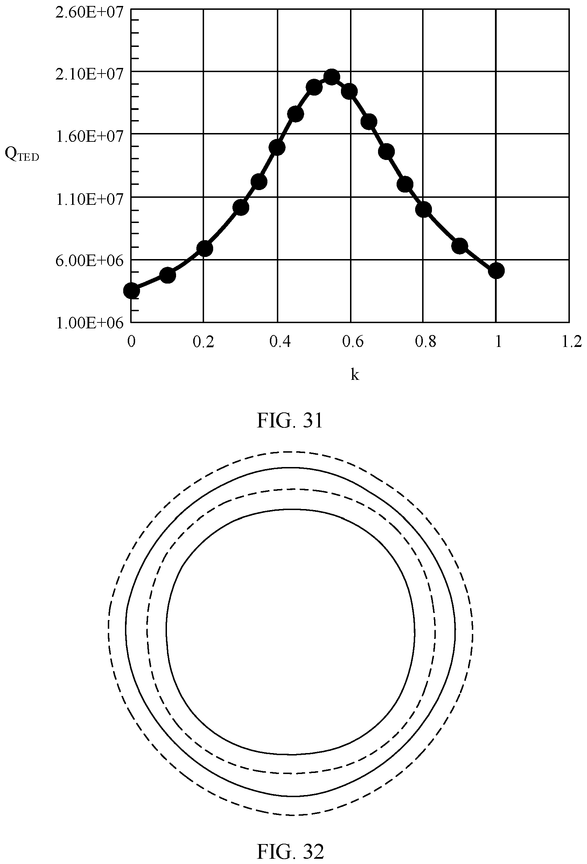

In an example, simulation is performed on the ring-shaped second resonator element 21, to obtain a Q value (that is, $Q_{TED}$) corresponding to thermoelastic dissipation of the second resonator element 21 at different k values. Refer to FIG. 31. It can be seen from FIG. 31 that, when k is 0.55, $Q_{TED}$ is largest, and largest $Q_{TED}$ corresponds to smallest thermoelastic dissipation TED. Therefore, k may be 0.55.

In addition, compared with a second resonator element 21 in a ring shape with an equal annulus width, $Q_{TED}$ of the second resonator element 21 designed according to the foregoing formula when k may be 0.55 is six times higher than $Q_{TED}$ of the second resonator element 21 in the ring shape with the equal annulus width.

In an example, the shape of the second resonator element 21 is a convex pattern, and the curvature radii at all edge positions of the second resonator element 21 are greater than zero, the value range of k may be greater than or equal to 3 and less than or equal to 5.

For example, if the shape of the second resonator element 21 is the disc shape, and the curvature radii at all edge positions of the second resonator element 21 are greater than zero, the value range of k may be greater than or equal to 3 and less than or equal to 5.

In an example, simulation is performed on the second resonator element 21 of the convex pattern, for example, the disc-shaped second resonator element 21. According to a simulation result, when k is 4, $Q_{TED}$ of the second resonator element 21 reaches a peak value, and in this case, corresponding thermoelastic dissipation TED is smallest. Therefore, k may be 4.

In addition, compared with a second resonator element 21 in a circular disc shape with an equal radius, $Q_{TED}$ of the second resonator element 21 designed according to the foregoing formula when k may be 4 is 13.6% higher than $Q_{TED}$ of the second resonator element 21 in the circular disc shape with the equal radius.

In an example, as shown in FIG. 29, a second sub-resonator 2 in which a second resonator element 21 in a ring shape with an unequal annulus width is located may be used in a scenario of a plurality of frequency bands. In this case, a resonator including the second sub-resonator 2 may be applied to the scenario of a plurality of frequency bands.

For example, in a clock scenario at a medium frequency or a low frequency (for example, lower than 10 MHz), a first-order breathing mode of the second resonator element 21 may be applied, and in a clock scenario at a high frequency (for example, higher than 200 MHz), a second-order breathing mode may be applied.

The first-order breathing mode and the second-order breathing mode are two operating modes of the second sub-resonator 2 in which the second resonator element 21 is located.

For the first-order breathing mode, refer to FIG. 32. A ring formed by two solid lines indicates a static state of the second resonator element 21, and a ring formed by two dashed lines indicates a state when the second resonator element 21 extends outward to a maximum displacement. In the first-order breathing mode, the second resonator element 21 is in vibration, and an inner circle and an outer circle of the second resonator element 21 extend or contract at the same time. In FIG. 32, extension is a process in which the ring formed by the two solid lines transforms to the ring formed by the two dashed lines, and contraction is a process in which the ring formed by the two dashed lines transforms to the ring formed by the two solid lines.

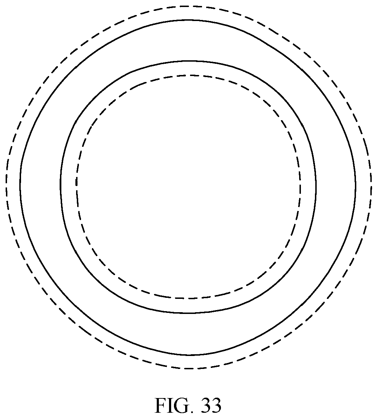

For the second-order breathing mode, refer to FIG. 33. A ring formed by two solid lines indicates a static state of the second resonator element 21, and a ring formed by two dashed lines indicates a state when the second resonator element 21 vibrates to a maximum displacement. In the second-order breathing mode, an inner circle and an outer circle of the second resonator element 21 in vibration move oppositely, that is, when the inner circle contracts, the outer circle extends, or when the inner circle extends, the outer circle contracts.

In an example, it can be seen from the foregoing analysis on the second sub-resonator 2 that if the second sub-resonator 2 is configured to impose a drive signal and perform a driving function, or if the second sub-resonator 2 is configured to impose a detection signal and perform a detection function, the second sub-resonator 2 includes both the second resonator element 21 and a second electrode 22.

Because there are a plurality of second sub-resonators 2, at least one of the plurality of second sub-resonators 2 further includes a second electrode 22.

If the second sub-resonator 2 including the second electrode 22 is the electrostatic resonator, the second electrode 22 and the second resonator element 21 are arranged at a spacing. For example, the second electrode 22 is located at a side of the second resonator element 21. To increase an area that the second electrode 22 and the second resonator element 21 face each other, the second electrode 22 is distributed in a circumferential direction of the second resonator element 21.

For example, if the second resonator element 21 is in the disc shape, the second electrode 22 is in a ring shape, and the second resonator element 21 is located inside a ring of the second electrode 22.

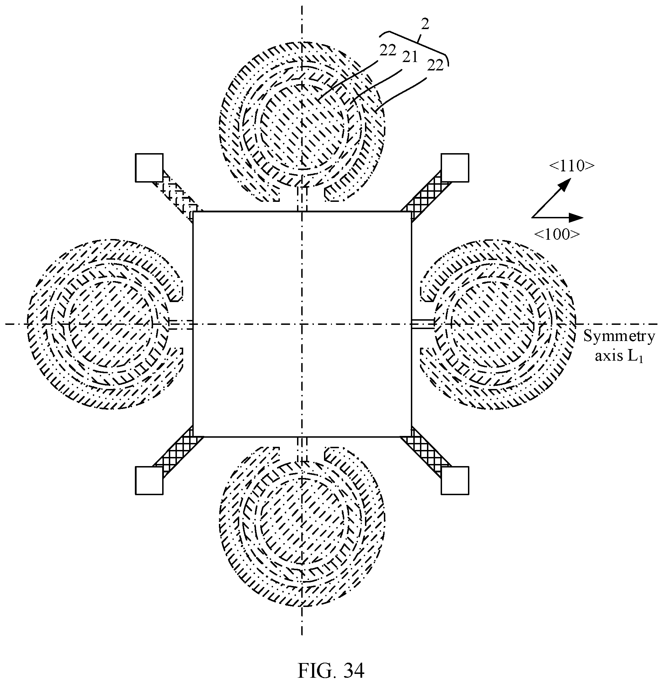

For another example, if the second resonator element 21 is in the ring shape, the second electrode 22 may be in a disc shape and located inside the ring of the second resonator element 21, or the second electrode 22 may be in a ring shape and the second resonator element 21 is located inside a ring of the second electrode 22. Certainly, there may also be two second electrodes 22. One is in a disc shape and located inside the ring of the second resonator element 21, and the other is in a ring shape and around the ring of the second resonator element 21. Refer to FIG. 34. A symmetry axis $L_1$ of the first sub-resonator 1 in FIG. 34 is in a crystal orientation in a <100> crystal orientation family.

Further, if a length on any straight line of the second resonator element 21 that is of the second sub-resonator 2 and that is the electrostatic resonator is negatively correlated with a Young's modulus in any target crystal orientation, any two spacings between the second resonator element 21 and the second electrode 22 are equal in different target crystal orientations. During application, if an absolute value of a difference between any two spacings between the second resonator element 21 and the second electrode 22 in different target crystal orientations are less than or equal to 170 micrometers, it may be considered that the two spacings are equal.

In this case, the second electrode 22 is arranged equidistant from the second resonator element 21, an edge that is of the second electrode 22 and that is close to the second resonator element 21 needs to be adapted and adjusted based on an edge that is of the second resonator element 21 and that is close to the foregoing edge.

In an example, as described above, the plurality of second sub-resonators 2 are fastened to the first sub-resonator 1 through connecting beams 5. An example in which a second resonator element 21 of the second sub-resonator 2 is in a ring shape, and a first resonator element 11 of the first sub-resonator 1 is in a plate shape is used.

In one solution, a position with a largest annulus width of the second resonator element 21 is connected to the plate-shaped first resonator element 11. For example, if a material of the second resonator element 21 is monocrystalline silicon, as shown in FIG. 34, an annulus width of the second resonator element 21 in any crystal orientation in the <100>crystal orientation family (for example, the [100] crystal orientation) is largest, and the second resonator element 21 may be connected to the first resonator element 11 at this position. As shown in FIG. 34, in this solution, the symmetry axis L1 of the resonator is in a crystal orientation in the <100> crystal orientation family.

In addition, compared with the coupled resonator obtained by connecting the second resonator element 21 in the ring shape with the equal annulus width to the square plate first resonator element 11, when k is 0.55, $Q_{TED}$ of the coupled resonator shown in FIG. 34 is 2.4 times higher than $Q_{TED}$ of the coupled resonator obtained by connecting the second resonator element 21 in the ring shape with the equal annulus width to the square plate first resonator element 11.

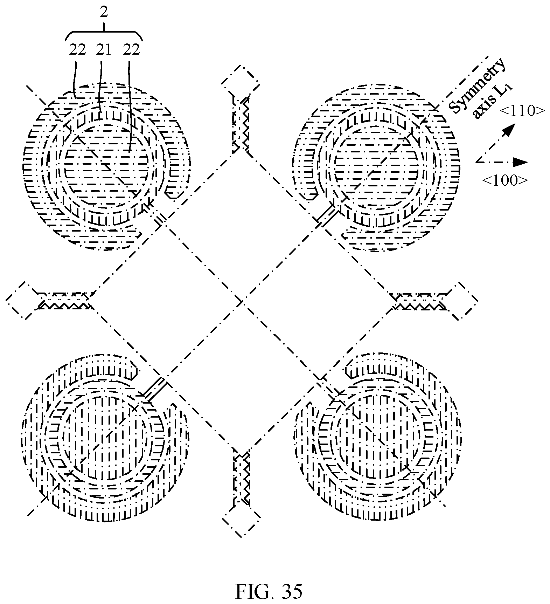

In another solution, a position with a smallest annulus width of the second resonator element 21 is connected to a plate-shaped first resonator element 11. For example, if a material of the second resonator element 21 is monocrystalline silicon, as shown in FIG. 35, an annulus width of the second resonator element 21 in any crystal orientation in the <110>crystal orientation family (for example, the [110] crystal orientation) is smallest, and the second resonator element 21 may be connected to the first resonator element 11 at this position. As shown in FIG. 35, in this solution, the symmetry axis L1 of the resonator is in a crystal orientation in the <110> crystal orientation family.

In addition, compared with the coupled resonator obtained by connecting the second resonator element 21 in the ring shape with the equal annulus width to the square plate first resonator element 11, when k is 0.55, $Q_{TED}$ of the coupled resonator shown in FIG. 35 is 4 times higher than $Q_{TED}$ of the coupled resonator obtained by connecting the second resonator element 21 in the ring shape with the equal annulus width to the square plate first resonator element 11.

The foregoing describes solutions in which a length of the second resonator element 21 on any straight line is negatively correlated with a Young's modulus in any target crystal orientation.

Embodiments of this application further provide an electronic component. The electronic component may be an oscillator, a filter, a sensor, or the like. The electronic component may include a peripheral circuit and the resonator. The peripheral circuit may include a drive circuit and a detection circuit. The drive circuit is connected to a drive electrode of the resonator, and the detection circuit is connected to a detection circuit of the resonator.

Embodiments of this application further provide a resonant system. The resonant system includes the electronic component. For example, if the electronic component is an oscillator, the resonant system may be specifically a clock system; if the electronic component is a filter, the resonant system may be an antenna system in communication; or if the electronic component is a sensor, the resonant system may be a sensor system.

The foregoing descriptions are merely embodiments of this application, but are not intended to limit this application. Any modification, equivalent replacement, or improvement made within the spirit and principle of this application should fall within the protection scope of this application.

**Claims**

1. A resonator, comprising a first sub-resonator (1) and a plurality of second sub-resonators (2), wherein the first sub-resonator (1) in vibration deforms in at least two non-parallel directions, the first sub-resonator (1) is connected to the second sub-resonators (2) in all the at least two non-parallel directions, and deformations in all the at least two non-parallel directions couple the first sub-resonator (1) to the plurality of second sub-resonators (2).

2. The resonator according to claim 1, wherein a shape of the first sub-resonator (1) is a plate shape.

3. The resonator according to claim 1 or 2, wherein a vibration mode of the first sub-resonator (1) is a bulk mode.

4. The resonator according to claim 3, wherein an acoustic wave generated by the first sub-resonator (1) in vibration is a transverse wave.

5. The resonator according to claim 3 or 4, wherein the bulk mode is one of a Lamé Lamé mode, a square extensional SE mode, a face-shear FS mode, a breathing mode, a wine glass WG mode, and a width-shear WS mode.

6. The resonator according to any one of claims 1 to 5, wherein the first sub-resonator (1) is symmetric, the plurality of second sub-resonators (2) are grouped into at least two groups of second sub-resonators (2), and each group of second sub-resonators (2) comprises two second sub-resonators (2); and
the two second sub-resonators (2) in each group of second sub-resonators (2) are symmetrically distributed about a symmetry axis of the first sub-resonator (1).

7. The resonator according to any one of claims 1 to 6, wherein the first sub-resonator (1) comprises a first resonator element (11) and a first electrode (12), and the first electrode (12) is distributed at a side of the first resonator element (11), so that the first resonator element (11) and the first electrode (12) form an electrostatic resonator.

8. The resonator according to claim 7, wherein the first sub-resonator (1) further comprises a piezoelectric layer (13) and an upper electrode layer (14), the piezoelectric layer (13) covers a surface of the first resonator element (11), and the upper electrode layer (14) covers a surface that is of the piezoelectric layer (13) and that is away from the first resonator element (11), so that the first resonator element (11), the piezoelectric layer (13), and the upper electrode layer (14) form a piezoelectric resonator.

9. The resonator according to claim 8, wherein the first sub-resonator (1) in vibration comprises a plurality of vibration types;

there are a plurality of piezoelectric layers (13), each piezoelectric layer (13) covers the surface of the first resonator element (11), and vibration types in a covered area are the same; and
there are a plurality of upper electrode layers (14), and a surface that is of each piezoelectric layer (13) and that is away from the first resonator element (11) is covered by the upper electrode layer (14).

10. The resonator according to claim 9, wherein a shape of the piezoelectric layer (13) is a triangle or trapezoid shape.

11. The resonator according to any one of claims 1 to 10, wherein a vibration mode of the second sub-resonator (2) is one of a breathing mode, a Lamé Lamé mode, a square extensional SE mode, a face-shear FS mode, a wine glass WG mode, and a width-shear WS mode.

12. The resonator according to any one of claims 1 to 11, wherein the second sub-resonator (2) is an electrostatic resonator comprising a second resonator element (21) and a second electrode (22).

13. The resonator according to claim 12, wherein a shape of a second resonator element (21) of at least one second sub-resonator (2) is a ring shape, and a second electrode (22) is distributed inside and/or outside a ring of the ring-shaped second resonator element (21).

14. The resonator according to claim 12, wherein a shape of a second resonator element (21) of at least one second sub-resonator (2) is a disc shape; and

a second electrode (22) of the disc-shaped second sub-resonator (2) is located outside a disc of the second resonator element (21) of the disc-shaped second sub-resonator (2), and is distributed in a disc circumferential direction of the second resonator element (21).

15. The resonator according to claim 13 or 14, wherein an outer sidewall of the second resonator element (21) of the at least one second sub-resonator (2) has a plurality of curvature radii.

16. The resonator according to any one of claims 13 to 15, wherein the outer sidewall of the second resonator element (21) of the at least one second sub-resonator (2) has a cut-off face (213).

17. The resonator according to any one of claims 13 to 16, wherein the second resonator element (21) of the at least one second sub-resonator (2) has a through-hole (211) running through a thickness direction.

18. The resonator according to any one of claims 13 to 17, wherein the outer sidewall of the second resonator element (21) of the at least one second sub-resonator (2) has a plurality of protrusions (212).

19. The resonator according to any one of claims 1 to 18, wherein a fastening anchor (4) for fastening the resonator is connected to the first sub-resonator (1).

20. The resonator according to claim 19, wherein the fastening anchor (4) is connected to a position that is of the first sub-resonator (1) and at which vibration is weakest.

21. The resonator according to claim 19 or 20, wherein the vibration mode of the first sub-resonator (1) is the Lamé mode, and the fastening anchor (4) is connected to a vertex angle of the first sub-resonator (1).

22. The resonator according to claim 19, wherein the vibration mode of the first sub-resonator (1) is the SE mode, and the fastening anchor (4) is connected to a side midpoint or a vertex angle of the first sub-resonator (1).

23. The resonator according to any one of claims 1 to 22, wherein at least one second sub-resonator (2) is connected to a position that is of the first sub-resonator (1) and at which vibration is strongest.

24. The resonator according to claim 23, wherein the vibration mode of the first sub-resonator (1) is the Lamé mode, and the at least one second sub-resonator (2) is connected to a side midpoint of the first sub-resonator (1).

25. The resonator according to any one of claims 1 to 22, wherein the vibration mode of the first sub-resonator (1) is the SE mode, and at least one second sub-resonator (2) is connected to the vertex angle or the side midpoint of the first sub-resonator (1).

26. The resonator according to any one of claims 1 to 25, wherein a material of the first sub-resonator (1), a material of each second sub-resonator (2), and a material of a coupling rod (3) connecting the first sub-resonator (1) to the second sub-resonator (2) are monocrystalline silicon materials or doped monocrystalline silicon materials.

27. The resonator according to any one of claims 1 to 26, wherein the resonator comprises a drive electrode and a detection electrode, the drive electrode is configured to input a drive signal for exciting vibration, and the detection electrode is configured to output a detection signal for detecting vibration; and

the drive electrode comprises an electrode of the first sub-resonator (1) and/or an electrode of at least one second sub-resonator (2), and the detection electrode comprises an electrode of the first sub-resonator (1) and/or an electrode of at least one second sub-resonator (2).

28. The resonator according to any one of claims 1 to 27, wherein a temperature coefficient of frequency TCF of the resonator is correlated with at least one of the following parameters:

the vibration mode of the first sub-resonator (1), the shape of the first sub-resonator (1), the material of the first sub-resonator (1), a vibration mode of each second sub-resonator (2), a shape of each second sub-resonator (2), the material of each second sub-resonator (2), a quantity of second sub-resonators (2), a relationship between the symmetry axis of the first sub-resonator (1) and a crystal orientation of a wafer, and a relationship between a symmetry axis of a second sub-resonator (2) having oriented crystallinity and the crystal orientation of the wafer, wherein the wafer is a wafer in which the resonator is located.

**29.** The resonator according to any one of claims 1 to 28, wherein each second sub-resonator (2) comprises a second resonator element (21), the second resonator element (21) has different Young's moduli in different target crystal orientations, and the target crystal orientation is parallel to a plane in which the second resonator element (21) is located; and

a length of the second resonator element (21) on any straight line is negatively correlated with a Young's modulus in any target crystal orientation, wherein the any straight line is a straight line that is parallel to the any target crystal orientation and that passes through a central position of the second resonator element (21).

**30.** The resonator according to claim 29, wherein an absolute value of a difference between $C(\theta)'$ and $C(\theta)$ is less than or equal to 0.05 $kC_0$, wherein

$$C(\theta) = \left(\frac{E_0}{E(\theta)}\right)^k \times C_0$$

$C(\theta)'$ indicates an actual length of the second resonator element (21) on the any straight line, $C(\theta)$ indicates a theoretical length of the second resonator element (21) on the any straight line, $E(\theta)$ indicates a Young's modulus of the second resonator element (21) in the any target crystal orientation, $\theta$ indicates an included angle between the any target crystal orientation and a reference target crystal orientation of the second resonator element (21), $C_0$ indicates a length of the second resonator element (21) in the reference target crystal orientation, $E_0$ indicates a Young's modulus of the second resonator element (21) in the reference target crystal orientation, and k is a constant greater than zero.

**31.** The resonator according to claim 30, wherein $E_0$ is less than $E(\theta)$.

**32.** The resonator according to claim 30 or 31, wherein a shape of the second resonator element (21) is a ring shape, and curvature radii at all positions inside and outside a ring of the second resonator element (21) are greater than zero; and a value range of k is greater than or equal to 0.3 and less than or equal to 0.8.

**33.** The resonator according to claim 32, wherein k is 0.55.

**34.** The resonator according to claim 30 or 31, wherein a shape of the second resonator element (21) is a convex pattern, and curvature radii at all edge positions of the second resonator element (21) are greater than zero; and a value range of k is greater than or equal to 3 and less than or equal to 5.

**35.** The resonator according to claim 34, wherein k is 4.

**36.** The resonator according to any one of claims 29 to 35, wherein at least one second sub-resonator (2) in the plurality of second sub-resonators (2) further comprises a second electrode (22), and the second sub-resonator (2) comprising the second electrode (22) is an electrostatic resonator; and the second electrode (22) is distributed in a circumferential direction of the second resonator element (21), and the second resonator element (21) is equidistant from the second electrode (22) in different target crystal orientations.

**37.** The resonator according to any one of claims 29 to 36, wherein a material of the second resonator element (21) is one of a monocrystalline material and a doped single crystal.

**38.** An electronic component, wherein the electronic component comprises a peripheral circuit and the resonator according to any one of claims 1 to 37, a drive circuit of the peripheral circuit is electrically connected to a drive electrode of the resonator, and a detection circuit of the peripheral circuit is electrically connected to a detection electrode of the resonator.

**39.** A resonant system, wherein the resonant system comprises the electronic component according to claim 38.

Phase
noise

~Rm/Q²

~Rm²

Δf

(a)

Frequency
shift Δf

TCF turnover
point

T₀

T ( )

(b)

FIG. 1

FIG. 2

FIG. 3

g

A

Electrode          Resonator          Electrode
                    element

FIG. 4

Second
direction

First
direction

FIG. 5

FIG. 6

FIG. 7

● Square Lamé-mode+breathe-mode resonator  ■ Square Lamé-mode resonator

FIG. 8

FIG. 9

FIG. 10

FIG. 11

FIG. 12

FIG. 13

D

A

C

B

FIG. 14

21

3

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

FIG. 31

FIG. 32

FIG. 33

FIG. 34

FIG. 35

<div align="center">**INTERNATIONAL SEARCH REPORT**</div>

| International application No. |
| --- |
| **PCT/CN2023/085909** |

| **A.** | **CLASSIFICATION OF SUBJECT MATTER** |
| --- | --- |

H03H9/17(2006.01)i

According to International Patent Classification (IPC) or to both national classification and IPC

| **B.** | **FIELDS SEARCHED** |
| --- | --- |

Minimum documentation searched (classification system followed by classification symbols)

IPC:H03H

Documentation searched other than minimum documentation to the extent that such documents are included in the fields searched

Electronic data base consulted during the international search (name of data base and, where practicable, search terms used)

CNABS; CNTXT; DWPI; VEN; USTXT; WOTXT; EPTXT; CNKI; IEEE: 谐振器, 振动, 模态, 品质因数, resonator, vibration, mode, quality factor

| **C.** | **DOCUMENTS CONSIDERED TO BE RELEVANT** |
| --- | --- |

| Category* | Citation of document, with indication, where appropriate, of the relevant passages | Relevant to claim No. |
| --- | --- | --- |
| X | US 2020407218 A1 (THE ROYAL INSTITUTION FOR THE ADVANCEMENT OF LEARNING / MCGILL UNIVERSITY) 31 December 2020 (2020-12-31) description, paragraphs 57-159, and figures 1-21 | 1-28, 38-39 |
| X | CN 113114149 A (INSTITUTE OF SEMICONDUCTORS, CHINESE ACADEMY OF SCIENCES) 13 July 2021 (2021-07-13) description, paragraphs 5-76, and figures 1-4 | 1-28, 38-39 |
| A | US 2019222196 A1 (GEORGIA TECH RESEARCH CORP.) 18 July 2019 (2019-07-18) description, paragraphs 49-83, and figures 1-10 | 1-39 |
| A | CN 215896718 U (SHENZHEN SUNWAY COMMUNICATION CO., LTD.) 22 February 2022 (2022-02-22) entire document | 1-39 |
| A | US 2018219529 A1 (MEMS-VISION INTERNATIONAL INC.) 02 August 2018 (2018-08-02) entire document | 1-39 |

| ☐ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **13 June 2023** | **19 June 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/085909**

| Patent document cited in search report | | | Publication date (day/month/year) | Patent family member(s) | | | Publication date (day/month/year) |
|---|---|---|---|---|---|---|---|
| US | 2020407218 | A1 | 31 December 2020 | None | | | |
| CN | 113114149 | A | 13 July 2021 | None | | | |
| US | 2019222196 | A1 | 18 July 2019 | US | 11533042 | B2 | 20 December 2022 |
| CN | 215896718 | U | 22 February 2022 | None | | | |
| US | 2018219529 | A1 | 02 August 2018 | US | 10742191 | B2 | 11 August 2020 |

Form PCT/ISA/210 (patent family annex) (July 2022)

**REFERENCES CITED IN THE DESCRIPTION**

**Patent documents cited in the description**

- CN 202210347471
- CN 202310323859